# EUROPEAN PATENT SPECIFICATION

(11) **EP 0 689 619 B1**
(45) Date of publication and mention of the grant of the patent: **30.05.2001**
(21) Application number: 94913894.5
(22) Date of filing: 07.03.1994
(51) Int. Cl.: C23C 16/00, B01F 3/04, F01B 31/00, C23C 16/44

(54) **APPARATUS AND METHOD FOR DELIVERING REAGENTS IN VAPOR FORM TO A CVD REACTOR**
VERFAHREN UND VORRICHTUNG ZUR ZUFÜHRUNG VON REAGENZIEN IN DAMPFFORM IN EINEN CVD-REAKTOR
APPAREIL ET METHODE D'INTRODUCTION DE REACTIFS EN PHASE GAZEUSE DANS UN REACTEUR DE DEPOSITION EN PHASE GAZEUSE PAR PROCEDE CHIMIQUE (CVD)

(30) Priority: 18.03.1993 US 32984; 07.01.1994 US 178933
(43) Date of publication of application: 03.01.1996
(73) Proprietor: ADVANCED TECHNOLOGY MATERIALS, INC., Danbury, CT 06810 (US)
(72) Inventor: KIRLIN, Peter S., Bethel, CT 06801 (US); GARDINER, Robin A., Bethel, CT 06801 (US); VAN BUSKIRK, Peter, Newton, CT 06470 (US)
(74) Representative: Marchant, James Ian
(86) International application number: US9402512
(87) International publication number: WO9421840

(56) References cited:
- EP-A- 0 420 596
- WO-A-93/03196
- FR-A- 1 097 534
- GB-A- 1 584 814
- US-A- 4 036 915
- US-A- 4 174 929
- US-A- 4 212 663
- US-A- 4 288 396
- US-A- 4 833 976
- US-A- 5 204 314
- US-A- 5 259 995
- PATENT ABSTRACTS OF JAPAN vol. 014, no. 211 (C-0715), 2 May 1990 & JP 02 048001 A (KOUJIYUNDO KAGAKU KENKYUSHO:KK), 16 February 1990,
- "FLEXIBLE SYSTEM FOR CONTROLLED CHEMICAL DELIVERY OF VAPORS" IBM TECHNICAL DISCLOSURE BULLETIN, vol. 33, no. 3B, August 1990, page 341/342 XP002029461

## Description

### Field of the Invention

This invention relates to an apparatus for vaporization of liquid reagents, as for example may be employed for delivering reagents in vapor form, e.g., flash vaporizable liquid source reagents in vapor form, to a chemical vapor deposition (CVD) reactor or other locus of use of the vapor phase reagent. Such apparatus may in specific embodiments thereof further comprise means and method for protecting the wetted parts of pumps that are used to meter air- or moisture-sensitive liquids, to protect such pumps from corrosion and degradation that can result when the liquids being pumped react with air or moisture to form solid particles. Such apparatus may in other specific aspects thereof further comprise means and method for preventing build-up of involatile compounds and subsequent flow blockage in the source reagent vaporization zone of the vaporization apparatus, to protect such vaporization zone from accumulation of solid or liquid material that may result in clogging.

### Description of the Related Art

Recently many refractory materials have been identified as having unique materials properties. The recently discovered high temperature superconducting (HTSC) materials include YBa₂Cu₃Oₓ, wherein x is from about 6 to 7.3, BiSrCaCuO, and TlBaCaCuO. Barium titanate, BaTiO₃, and barium strontium titanate, BaₓSr₁₋ₓTiO₃, have been identified as ferroelectric and photonic materials with unique and potentially very useful properties. BaₓSr₁₋ₓNb₂O₆ is a photonic material whose index of refraction changes as a function of electric field and also as a function of the intensity of light upon it. Lead zirconate titanate, PbZr₁₋ₓTiₓO₃, is a ferroelectric material whose properties are very interesting. The Group II metal fluorides, BaF₂, CaF₂, and SrF₂, are materials that are useful for scintillation detecting and coating of optical fibers. Refractory oxides such as Ta₂O₅ are seeing expanded use in the microelectronics industry; Ta₂O₅ is envisioned as a thin-film capacitor material whose use may enable higher density memory devices to be fabricated.

Many of the potential application of these materials require their use in thin film, coating, or layer form. The films or layers may also be advantageously epitaxially related to the substrate upon which they are formed. Applications in which the refractory materials may need to be deposited in film or layer form include integrated circuits, switches, radiation detectors, thin film capacitors, holographic storage media, and various other microelectronic devices.

Chemical vapor deposition (CVD) is a particularly attractive method for forming these layers because it is readily scaled up to production runs and because the electronic industry has a wide experience and an established equipment base in the use of CVD technology which can be applied to new CVD processes. In general, the control of key variables such as stoichiometry and film thickness, and the coating of a wide variety of substrate geometries is possible with CVD. Forming the thin films by CVD will permit the integration of these materials into existing device production technologies. CVD also permits the formation of layers of the refractory materials that are epitaxially related to substrates having close crystal structures.

CVD requires that the element source reagents must be sufficiently volatile to permit gas phase transport into the deposition reactor. The element source reagent must decompose in the reactor to deposit only the desired element at the desired growth temperatures. Premature gas phase reactions leading to particulate formation must not occur, nor should the source reagent decompose in the lines before reaching the reactor deposition chamber. When compounds are desired to be deposited, obtaining optimal properties requires close control of stoichiometry which can be achieved if the reagent can be delivered into the reactor in a controllable fashion. In addition, the reagents must not be so chemically stable that they do not react in the deposition chamber.

Thus a desirable CVD reagent is fairly reactive and volatile. Unfortunately, for many of the refractive materials described above, volatile reagents do not exist. Many potentially highly useful refractory materials have in common that one or more of their components are elements, such as the Group II metals barium, calcium, or strontium, or early transition metals zirconium or hafnium, for which no volatile compounds well-suited for CVD are known. In many cases, the source reagents are solids whose sublimation temperature may be very close to the decomposition temperature, in which case the reagent may begin to decompose in the lines before reaching the reactor, and it will be very difficult to control the stoichiometry of the deposited films.

In other cases, the CVD reagents are liquids, but their delivery into the CVD reactor in the vapor phase has proven problematic because of problems of premature decomposition or stoichiometry control.
The problem of controlled delivery of CVD reagents into deposition reactors was addressed by the inventors in U.S. Patent Application Serial No. 07/807,807, which is a continuation of U.S. Patent Application Serial No. 07/549,389, "Method for Delivering an Involatile Reagent in Vapor Form to a CVD Reactor," and further elaborated in U.S. Patent Application Serial No. 07/927,134, "Apparatus and Method for Delivery of Involatile Reagents".

As described and claimed in these patent applications, the delivery of reagents into the deposition chamber in vapor form is accomplished by providing the reagent in a liquid form, neat or solution, and flowing the reagent liquid onto a flash vaporization matrix structure which is heated to a temperature sufficient to flash vaporize the reagent source liquid. A carrier gas may optionally be flowed by the flash vaporization matrix structure to form a carrier gas mixture containing the flash vaporized reagent source liquid.

The means for flowing the reagent liquid onto the flash vaporization matrix may be any suitable liquid pumping means, such as a positive displacement liquid pump. In practice, the method chosen for pumping the liquid is often a piston pump.

Serious problems of pump particle generation and hence plugging of orifices and degradation of seals are encountered when air- or moisture-sensitive liquids are metered by piston pumps that have moving, wetted parts. For example, when the metering piston's wetted surfaces are exposed to air, reactions between the liquid being pumped and air or moisture can occur that produce oxidic particles. These particles erode the piston seals, leading to pump breakdown.

A related problem is the degradation of pump seals that can result when the reagent being pumped is a solid dissolved in a relatively volatile liquid solvent. The solvent evaporates, leaving behind the solid which abrades the seal.

Many reactive liquids that are used as source reagents in processes for film or layer deposition have caused problems in pumping. Some of these compounds are readily hydrolyzed by moisture in the air, such as tantalum ethoxide, tetraethyl orthosilicate (TEOS), other metal alkoxide compounds such as zirconium tetra-tert-butoxide, and metal amide reagents such as tetrakis(dialkylamido)titanium compounds.

These moisture-sensitive compounds react to form oxide particles that are especially hard on the piston seals. Other compounds used in deposition processes are highly air-sensitive. Examples include the aluminum source reagents such as tri-isobutylaluminum and trimethylamine alane (a solid which may be used in solution in a solvent which is chemically inert to the aluminum reagent, such as hexane), other Group III reagents such as trimethylgallium, and some Group V reagents such as trialkylantimony compounds. Such compounds react with oxygen, likewise to form destructive oxide particles.

For example, when a dual piston metering pump was used to deliver tantalum pentaethoxide, a moisture-sensitive liquid, tantalum oxide built up on the pistons after tens of hours which eroded the piston seals and eventually stopped any piston movement.

This problem with pumping reactive liquids has hindered the usage of liquid delivery systems of all sorts, including but not limited to the type described and claimed in U.S. Patent Applications Serial Nos. 07/807,807 and 07/927,134. In reactive liquids pumping systems that do not employ the inert purge blanket system of the present invention, maintenance becomes a problem. Such pumping systems have a shorter mean time to failure and frequent downtime for maintenance steps such as seal replacement.

Similar pumping problems have been encountered in other systems. In most cases, the solution proposed to address attack on piston seals and other wetted parts has been to coat the parts with a chemically resistant coating, for example Teflon® coatings or coatings of other inert polymeric material(s).

This approach, however, does not address the problems created by oxide particle formation as described above. While the pump parts may thereby be protected from chemical attack, the particles still have the potential to physically abrade moving parts, clog orifices, and score the chemically resistant coating(s).

U.S. Patent 3,516,760 describes a method to protect a piston pump conveying a corrosive reaction mixture, at least one constituent of which is a liquid which does not corrode the material in the stuffing box. A suitable amount of the noncorrosive liquid is injected into an annular gap surrounding the piston, under pressure sufficient to prevent the corrosive mixture from reaching the stuffing box. In the manufacture of urea, the packing material is protected from corrosive attack by the carbamate intermediate by injecting liquid ammonia into the annular gap. As ammonia enters the carbamate mixture, this procedure provides a means for returning ammonia which has been lost from the mixture, thus increasing the yield of carbamate as well as preserving the packing in the stuffing box. The ammonia acts as a scavenger, since it is one of the reactants in the process. This approach is not broadly applicable, since not all air- or moisture-sensitive liquids being pumped contain a noncorrosive component, and indeed not all liquids being pumped are mixtures.

When the film being deposited by CVD is a multicomponent substance rather than a pure element, such as barium titanate or the oxide superconductors, controlling the stoichiometry of the film is critical to obtaining the desired film properties. In such materials, which may form films with a wide range of stoichiometries, the controlled delivery of known proportions of the source reagents into the CVD reactor chamber is required.

In other cases, the CVD reagents are liquids, but their delivery into the CVD reactor in the vapor phase has proven problematic because of problems of premature decomposition or stoichiometry control. Examples include the deposition of tantalum oxide from the liquid source tantalum ethoxide and the deposition of titanium nitride from bis(dialkylamide)titanium reagents.

While source reagent liquid delivery systems present distinct advantages over conventional techniques, there is often some fraction of the precursor compound that decomposes into very low volatility compounds that remain at the vaporization zone. This problem is a important issue in CVD processes that use thermally unstable solid source precursors which display significant decomposition at conditions needed for sublimation. Such decomposition can occur in all reagent delivery systems that involve a vaporization step, not only in the vaporizer in a liquid delivery system as described above but also in more conventional reagent delivery systems that include bubblers and heated vessels operated without carrier gas.

Although well-behaved CVD precursors vaporized under "ideal" conditions will form no deposits or residue at the vaporization zone, deviations from this situation are common and can be divided into several categories:
1) Reactive impurities in either the precursor or in the carrier gas decompose at the vaporizer temperatures.
2) Spatial and temporal temperature variations occur in the vaporization zone, with temperatures in some regions being sufficient to bring about decomposition.
3) CVD precursors are employed which are thermally unstable at the sublimation temperature.

Optimization of the conditions used in the vaporizer of reagent delivery systems can minimize the fraction of the delivered precursor that decomposes (and remains) at the vaporization zone, but virtually all solid and liquid precursors undergo some decomposition when they are heated for conversion to the gas phase, although this fraction is negligibly small in "well-behaved" compounds. Use of precursors that tend to decompose near their vaporization temperature may be mandated by availability (i.e., the selected precursor possessed the best properties of all available choices) or by economics, in the case where precursor cost is strongly dependent on the complexity of the synthesis.

Additionally, CVD precursors often contain impurities, and presence of those impurities can cause undesirable thermally activated chemical reactions at the vaporization zone, also resulting in formation of involatile solids and liquids at that location. For example, a variety of CVD precursors (such as tantalum pentaethoxide) are water sensitive and hydrolyzation can occur at the heated vaporizer zone to form tantalum oxide particulates that may be incorporated into the growing tantalum oxide film with deleterious effects.

Despite the advantages of the liquid delivery approach (which include improved precision and accuracy for most liquid and solid CVD precursors and higher delivery rates), this issue is the only serious impediment to widespread use of the technique. In the field of the present invention, there have been various apparatus and methodologies proposed to overcome the above-discussed deficiencies.

U.S. Patent 5,204,314 describes a system for liquid delivery vaporization of source reagents for metalorganic chemical vapor deposition. The metalorganic source reagent is dissolved in a suitable solvent medium and flash vaporized on a vaporization matrix structure having a high surface to volume ratio, such as a screen, mesh, porous sintered metal matrix or the like. The resulting flashed vapor is then flowed to a downstream chemical vapor deposition reactor and contacted with a substrate to deposit a metal-containing film from the precursor vapor.

French Patent 1, 097,534 discloses a piston arrangement for pumps and compressors in which the piston shaft is contacted with a washing liquid capable of dissolving oil.

U.S. Patent 5,259,995 discloses a vapor pressure regulating device in which a carrier gas is flowed through a wetted wick structure to evaporate liquid into the carrier gas and thereby maintain a desired subsaturation of vapor pressure of the liquid.

U.S. Patent 4,833,976 describes an axial pump that is sealed by annular gaskets with a flow of sealing fluid being passed through the sealing fluid zone. A flush chamber is arranged for removal of ingressed material in the sealing fluid zone by flow through the sealing fluid zone of a flush fluid.

IBM Technical Disclosure Bulletin, August, 1990, Volume 33, No 3B, pp. 341-342 describes a system for chemical vapor delivery, in which a liquid chemical stored in a source bottle is flowed by a fluid metering system to an evaporator, with a resulting vapor being passed to a downstream tool. A purge gas/solvent is disclosed for cleaning of the components wet by the chemical. The evaporator in this system is an agitated film unit.

Accordingly, it is an object of the present invention to provide a means and method for extending the maintenance and cleaning cycles of vaporizers in liquid delivery systems used to introduce a variety of precursors to CVD reactors.

It is another object of the present invention to provide a means and method for protecting the moving parts of pumps used to deliver air- and moisture-sensitive liquids by which these previous obstacles are overcome.

It is a still further object of the invention to provide an improved liquid reagent vaporization apparatus and method.

Other objects and advantages of the present invention will be more fully apparent from the ensuing disclosure and appended claims.

### SUMMARY OF THE INVENTION

The present invention in one aspect thereof relates to an apparatus for vaporizing a source reagent of non-vapor character, to produce a vapor for transport to a locus of use, said apparatus comprising a vaporization chamber including a housing defining there within an enclosed interior vaporization volume;
means for feeding source reagent to the interior volume of the housing; vaporization means disposed within the interior volume of said housing and in receiving relationship to the feed means, for receiving source reagent and effecting vaporization thereof; and
means for selectively feeding to the interior volume, for contact with the vaporization means and interior surfaces of the housing, a cleaning fluid which is cleaningly effective to at least partially remove vaporization deposits from said vaporization means and interior surfaces of the housing characterized in that the vaporization chamber has a liquid flow passage formed on an enclosing interior wall surface thereof;
   the vaporization means comprises at least one porous wall member having inner and outer wall member surfaces, wherein said porous wall member is positioned with the outer wall member surface thereof in proximate, and preferably contiguous, relationship to the enclosing interior wall surface having said liquid flow passage formed thereon, so that the outer wall member surface of the porous wall member overlies said liquid flow passage, and so that the inner wall member surface of the porous wall member is presented to the interior volume of the vaporization chamber;
means are provided for heating the porous wall member to a temperature for vaporization of the vaporizable liquid;
the means for feeding source reagent to the interior volume of the housing deliver vaporizable liquid to the liquid flow passage for contact with the porous wall member heated to said temperature for vaporization of the vaporizable liquid, so that resulting vapor formed by said contact passes through said porous wall member to the interior volume of the vaporization chamber.

In another aspect, the present invention relates to a method of vaporizing a non-vapor source reagent, and at least partially removing deposition by-products of such vaporization, said process comprising:
providing an apparatus for vaporizing a source reagent of non vapor character, to produce a vapor for transport to a locus of use, said apparatus comprising:
a vaporization chamber including a housing defining therewithin an enclosed interior vaporization volume;
means for feeding source reagent to the interior volume of the housing;
   vaporization means disposed within the interior volume of said housing and in receiving relationship to the feed means, for receiving source reagent and effecting vaporization thereof; and
vaporizing the source reagent in the housing for a predetermined time, and flowing resulting vaporized reagent out of the housing;
characterised by:
said apparatus including means for selectively feeding to the interiot volume, for contact with the vaporization means and interior surfaces of the housing, a cleaning fluid which is cleaningly effective to at least partially remove vaporization deposits from said vaporization means and interior surfaces of the housing; and
after said predetermined time, terminating flow of source reagent and vaporized reagent, and flowing into said housing a cleaning fluid which is cleaningly effective for at least partial removal of deposits produces by said vaporization.

The present invention may also relate to a method for protecting the moving parts of a pump that is used to pump air- or moisture-sensitive liquids, comprising blanketing the wetted parts of the pump with an inert medium. In another aspect, the invention relates to an apparatus for protecting the wetted, moving parts of pumps used to pump air- or moisture-sensitive liquids. The apparatus provides a mantle within which an inert medium is flowed around the moving, wetted pumps parts to continually purge them of any air or moisture.

In a further aspect, the present invention relates to a means and method for preventing build-up of involatile compounds and subsequent flow blockage in the source reagent vaporization zones of chemical vapor deposition reactors. Such aspect of the invention comprises a method for the in-situ cleaning of the vaporization zone in either the high surface area heated zone of a liquid delivery system or in other, conventional vapor sources that include bubblers and heated vessels operated without carrier gas.

The cleaning involves dissolving decomposition products produced during source vaporization, and this may be accomplished by controlled delivery of a specific fluid to the vaporization zone via a multiple position valve in the fluid plumbing line normally used for delivery of the CVD precursor to that zone or through a separate plumbing line to that location. The fluid is selected on the basis of several criteria, which include the following:
1) The fluid should dissolve the CVD source and decomposition products or should react with them to form soluble products.
2) To protect the integrity of the process, the fluid should be free of particles.
3) The fluid should have a high vapor pressure (>200 torr at room temperature).

The in-situ cleaning fluid is pumped to the vaporization zone periodically, either after each deposition run or less frequently. Intervals at which cleaning occurs can be set as regular intervals, or cleaning can occur in response to a change in a variable being monitored, such as the build-up of back-pressure in a vaporizer structure that is beginning to clog.

The resulting solution of decomposition products and solvents is then flushed away from the vaporization zone, leaving the area clean for subsequent vaporizing of sources. The used cleaning fluid is then collected in a scrubber or a trap that can be periodically cleaned or exchanged for another which has been renewed, or alternatively is recycled for use in several cleaning cycles.

In a specific apparatus aspect of such cleaning system arrangement, a vaporizer flushing apparatus is provided, comprising a vaporizer by means of which CVD precursors are transformed either from gaseous or solids into the gas phase, which may be heated, with a fluid source for introduction of cleaning liquid(s) or gas(es) to the vaporizer, a multiple position valve that allows introduction of either cleaning fluids or CVD precursors to the vaporization zone, a valve to regulate flow of gaseous precursors to the CVD reactor (on or off), a valve to regulate flow of gaseous precursors directly to the residual chemical trap (on or off), the CVD reactor, in which gas phase reactant gases undergo chemical reactions resulting in film formation on a substrate, a valve to regulate flow of gaseous precursors from the CVD reactor to the trap (on or off), a trap for residual chemicals that are collected either by condensation of flowing gases there or by collection of liquids that are comprised of involatile solid and liquid residue from the vaporizer, and a vacuum pump needed to operate the apparatus below atmospheric pressure.

In yet another aspect, the present invention relates to a chemical vapor deposition system encompassing the above-described specific aspects of the invention, and comprising:
(A) an apparatus for vaporizing a vaporizable liquid, comprising:
   a vaporization chamber including an interior volume therewithin and at least partially bounded by an enclosing interior wall surface having a liquid flow passage formed thereon;
   a vaporization element disposed in said vaporization chamber and comprising at least one porous wall member having inner and outer wall member surfaces, wherein said porous wall member is positioned with the outer wall member surface thereof in proximate, and preferably contiguous, relationship to the enclosing interior wall surface having said liquid flow passage formed thereon, so that the outer wall member surface of the porous wall member overlies said liquid flow passage, and so that the inner wall member surface of the porous wall member is presented to the interior volume of the vaporization chamber;
   means for heating the porous wall member to a temperature for vaporization of the vaporizable liquid;
   means for delivering vaporizable liquid to the liquid flow passage for contact with the porous wall member heated to said temperature for vaporization of the vaporizable liquid, so that resulting vapor formed by said contact passes through said porous wall member to the interior volume of the vaporization chamber; and
   means for discharging vapor from the interior volume of the vaporization chamber;
(B) a pump assembly for supplying said vaporizable liquid to said means for delivering same to the liquid flow passage, said pump assembly comprising:
   a pump block with an interior pumping cavity;
   a piston positioned in the pumping cavity for reciprocatable movement therein;
   a first liquid seal mounted in the pumping cavity and circumscribingly arranged about the piston (i) to effect sealing between the piston and the pumping cavity during reciprocating movement of the piston in the cavity, and (ii) to bound an inner liquid pumping volume of the pumping cavity;
   a second fluid seal mounted in the pumping cavity and circumscribingly arranged about the piston to effect sealing between the piston and the pumping cavity during reciprocating movement of the piston in the cavity, the second fluid seal being in spaced-apart relationship to the first liquid seal to define an intraseal volume of the pumping cavity therebetween;
   an inlet liquid passage joined to the inner liquid pumping volume for introduction of feed liquid thereto;
   an outlet liquid passage joined to the inner liquid pumping volume for discharging of pressurized liquid therefrom;
   a fluid inlet passage joined to the intraseal volume of the pumping cavity for introduction of a purge gas or liquid thereto; and
   a fluid outlet passage joined to the intraseal volume of the pumping cavity for discharging of purge gas or liquid therefrom,
   whereby a portion of the piston during reciprocating movement thereof is translated between the liquid pumping volume of the pumping cavity and the intraseal volume of the pumping cavity; and
(C) means for selectively feeding to the interior volume, for contact with the vaporization element and interior surfaces of the housing, a cleaning fluid which is cleaningly effective to at least partially remove vaporization deposits from said vaporization element and interior surfaces of the housing.

Other aspects and features of the invention will be more fully apparent from the ensuing disclosure and appended claims.

### DESCRIPTION OF THE DRAWINGS

Figure 1A is a schematic representation of a dual piston metering pump incorporating an inert blanket purge, showing the piston in the fully inserted position.

Figure 1B is a schematic representation of a dual piston metering pump incorporating an inert blanket purge, showing the piston in the fully withdrawn position.

Figure 2 shows an exploded schematic view of a dual piston metering pump incorporating an inert blanket purge.

Figure 3 is a schematic representation of a chemical vapor deposition system comprising a vaporizer flushing apparatus of the present invention.

Figures 4a, 4b and 4c are cutaway views from three angles successively rotated 90° of a vaporizer assembly incorporating the cleaning subassembly of the present invention. The view of Figure 4b is rotated 90° about the vertical axis from Figure 4a. The view of Figure 4c is rotated 180° about the vertical axis from Figure 4a.

Figure 5 is a schematic representation of a liquid reagent vaporization system according to one embodiment of the invention.

### DETAILED DESCRIPTION OF THE INVENTION, AND PREFERRED EMBODIMENTS THEREOF

In respect of the pump purge arrangement forming a part of the present invention, such aspect of the invention is based on the observation that if the wetted, moving parts of a pump used to pump air- or moisture-sensitive liquids were protected from exposure to air or moisture, the service life of the pump could be dramatically extended. Oxide particle build-up could be avoided or minimized, with a concomitant improvement in pump performance and increase in the interval between service shut-downs which are required to prevent catastrophic seal failure.

The inert medium is purged through a chamber surrounding the pump's moving, wetted parts. The inert medium may be flowed through the chamber continually or intermittently, with the proviso that the atmosphere surrounding the moving, wetted pump parts must be kept substantially free of reactive species such as oxygen or moisture.

The inert medium is a fluid selected with the criterion that it must not react with the chemical being pumped. The inert fluid may be a gas or liquid. A dry, inert gas such as argon, nitrogen or helium is a preferred inert medium, although there are cases where ultra-dry air may be adequate. Other dry inert gases such as neon, krypton, or hydrogen could also be used. Alternatively, the liquid being pumped could be used as the inert fluid medium to purge the pumps wetted parts, in a recirculating system that would be hermetically sealed.

Degradation of pump seals can result when the reagent being pumped is a solid dissolved in a relatively volatile liquid solvent. The solvent evaporates, leaving behind the solid which abrades the seal. In such cases, the addition of a low vapor pressure liquid to the reagent solution alleviates the problem by preventing the solution from drying out on the pump seals. As used herein, a low vapor pressure liquid refers to liquids having boiling points above about 150°C. In addition, the low vapor pressure liquid added to the reagent solution should (1) have a low vapor pressure, (2) be at least moderately soluble in the relatively volatile liquid solvent, and (3) should be a liquid in which the solid reagent is soluble.

Solid reagents such as those described in U.S. Patent Application Serial No. 07/807,807, "Method for Delivering an Involatile Reagent in Vapor Form to a CVD Reactor," are customarily dissolved in a low-boiling alcohol or ether solvent such as isopropanol or tetrahydrofuran or isopropanol/tetrahydrofuran mixtures. The added low volatility liquid can advantageously be a polyether such as tetraglyme (tetraethylene glycol dimethyl ether, boiling point ~275°C) or triglyme (triethylene glycol dimethyl ether, boiling point ~216°C). Polyamines such as tetraethylenepentamine (boiling point 340°) or triethylenetetramine (boiling point 266-267°C) could also be selected. These low volatility liquids are soluble in the alcohol or ether solvent and also dissolve the solid reagents. For example, when the solvent is isopropanol or an isopropanol/tetrahydrofuran mixture and the solid reagent is a metal beta-diketonate complex, tetraglyme has been shown to be effective as the low volatility liquid. A typical solution is exemplified by 0.1M barium(thd)₂ (bis(2,2,6,6-tetramethyl-3,5-heptanedionato)barium) dissolved in 9:1 isopropanol:tetraglyme.

The chamber surrounding the pump's wetted parts may be of any suitable size and shape, with the key proviso that a gas or liquid may be flowed through the chamber so as to completely blanket all moving, wetted parts of the pump.

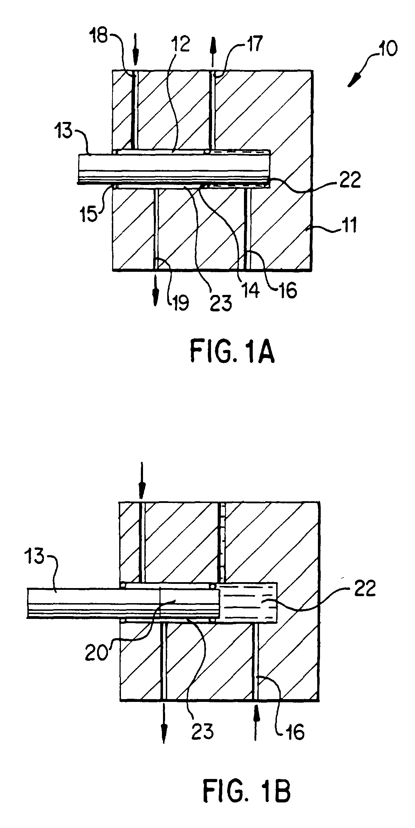

Figure 1A is a schematic representation of a dual piston metering pump **10** incorporating an inert blanket purge, showing the piston in the fully inserted position, with Figure 1B showing the pump **10** with the piston in the fully withdrawn position. Pump block **11** has an interior pumping cavity **12** and a piston **13** positioned in the pumping cavity for reciprocatable movement therein.

A first liquid seal **14** is mounted in the pumping cavity and circumscribingly arranged about the piston so as (i) to effect sealing between the piston and the pumping cavity during reciprocating movement of the piston in the cavity and (ii) to bound an inner liquid pumping volume **22** of the pumping cavity.

A second gas seal **15** is mounted in the pumping cavity and circumscribingly arranged about the piston to effect sealing between the piston and the pumping cavity during reciprocating movement of the piston in the cavity, this second gas seal being in spaced-apart relationship to the first liquid seal **14** so as to define an intraseal volume **23** of the pumping cavity therebetween.

An inlet liquid passage **16** is joined to the inner liquid pumping volume **22** for introduction of feed liquid thereto, and an outlet liquid passage **17** is joined to the inner liquid pumping volume for discharging of pressurized liquid therefrom. A gas inlet passage **18** is joined to the intraseal volume **23** of the pumping cavity for introduction of a purge gas thereto, and a gas outlet passage **19** joined to the intraseal volume of the pumping cavity for discharging of the purge gas therefrom.

Thus a portion of the piston during reciprocating movement thereof is translated between the liquid pumping volume **22** of the pumping cavity and the intraseal volume **23** of the pumping cavity.

A flow of inert gas is maintained at a suitable flow rate, e.g., 0.2 - 5 standard liters per minute (slpm) during the operation of the pump. When the piston **13** is in the fully inserted position (Figure 1A), pressurized liquid is discharged from pump block **11** via outlet liquid passage **17**. When the piston **13** is in the withdrawn position (Figure 1B), liquid flows to the pumping cavity via inlet liquid passage **16**. The piston's wetted surface **20** remains in the purged space (intraseal volume **23**), and therefore is protected from contact with reactive species such as water or oxygen in the surrounding ambient atmosphere.

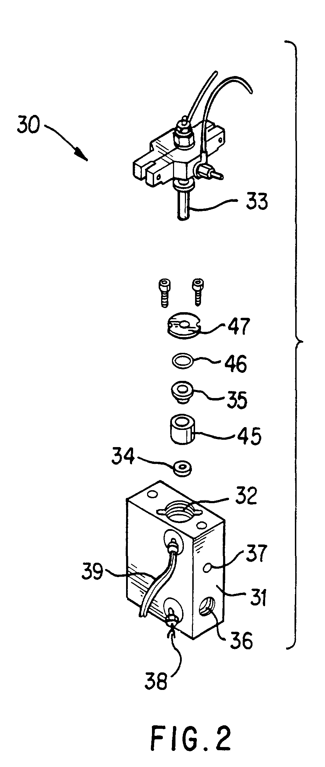

Figure 2 shows an exploded schematic view of a dual piston metering pump **30** incorporating an inert blanket purge. Pump block **31** has an interior pumping cavity **32** and a piston **33** which during use is positioned in the pumping cavity for reciprocatable movement therein.

A first liquid seal **34** is mounted in the pumping cavity with piston seal holder **45** so as to effect sealing between the piston and the pumping cavity during reciprocating movement of the piston in the cavity, and to bound an inner liquid pumping volume of the pumping cavity.

A second gas seal **35** is mounted in the pumping cavity to effect sealing between the piston and the pumping cavity during reciprocating movement of the piston in the cavity, this second gas seal being in spaced-apart relationship to the first liquid seal **34** so as to define an intraseal volume of the pumping cavity therebetween.

An inlet liquid passage **36** is joined to the inner liquid pumping volume for introduction of feed liquid thereto, and an outlet liquid passage **37** is joined to the inner liquid pumping volume for discharging of pressurized liquid therefrom.

A gas inlet passage **38** is joined to the intraseal volume of the pumping cavity for introduction of a purge gas thereto, and a gas outlet passage **39** is joined to the intraseal volume of the pumping cavity for discharging of the purge gas therefrom. These are held in place by O-ring **46** and piston seal cover **47**. Thus a portion of the piston during reciprocating movement thereof is translated between the liquid pumping volume of the pumping cavity and the intraseal volume of the pumping cavity.

In respect of the self-cleaning apparatus aspect of the present invention, such aspect of the invention is based on the observation that under certain conditions, involatile residue can collect in a vaporizer used in a reagent delivery system for a chemical vapor deposition process. The average time taken for the build up of these decomposition products to halt the vaporization process will determine the mean time before failure (MTBF) of the liquid delivery system of which the vaporization zone is a subsystem.

As the build up of decomposition products occurs they can be a cause of chemical and particulate contamination. If these issues become apparent cleaning of the vaporization zone will be necessary. The frequency of maintenance will determine the mean time to repair (MTR). Both the MTR of a system and subsequently MTBF are of utmost importance for customers using this technology. The removal of decomposition products in an efficient way reduces the contamination liability associated with the decomposition products and thus increases the MTBF.

The present invention contemplates a method to periodically clean the high surface area vaporization zone of the decomposition products using a suitable cleaning fluid. The resulting solution is then flushed into a container which can be removed for disposal or can be connected to provide recycle for reuse.

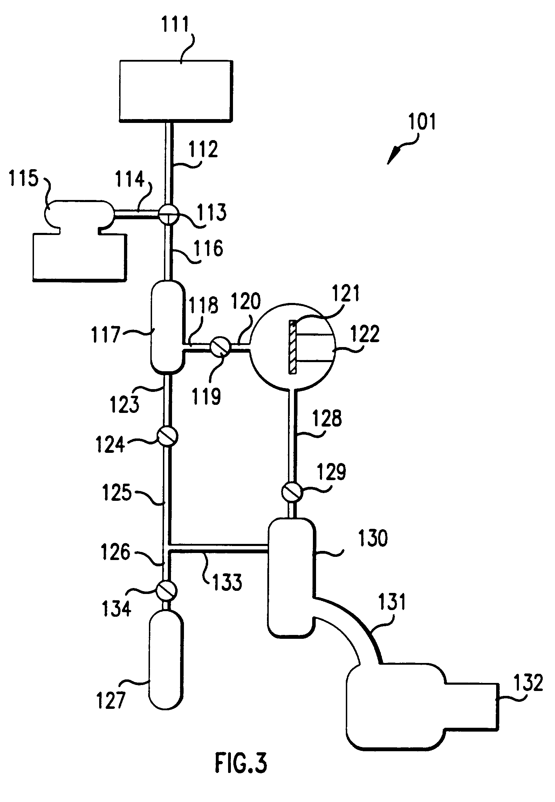

A schematic of a chemical vapor deposition system **101** employing the vaporizer flush invention is shown in Figure 3. During chemical vapor deposition of films, liquid source reagent or solid source reagent dissolved in appropriate solvent flows from reagent source reservoir **111** through fluid conduit **112** to three-way valve **113**, which is in the open position. The reagent liquid flows through conduit **116** into vaporizer **117**, which may be of the type described in U.S. Patent No. 5,204,314, "Method For Delivering an Involatile Reagent in Vapor Form to a CVD Reactor".

The vaporized source reagent flows through conduit **118,** on-off valve **119** which is in the open position, and conduit **120** to the chemical vapor deposition reactor chamber **122**, wherein decomposition of the source reagent occurs to deposit films on substrate **121**. Decomposition may be thermal, photochemical, plasma-induced, or any other workable type of chemical vapor deposition. Waste gases from the CVD reactor, including unreacted source reagent, flow out of the reactor chamber **122**, through conduit **128** and on-off valve **129** which is in the open position to trap or scrubber **130** which retains solids and liquids. The trap is connected to the vacuum pump **132** by conduit **131**. The scrubber or trap **130** may be a cold trap or any of a wide variety of scrubber types as are well-known in the art. The scrubber or trap protects the vacuum pump.

Cleaning fluid is held in cleaning fluid reservoir **115**, which may be a liquid vessel/pump combination in the case of liquid cleaning fluids or a gas cylinder in the case of gaseous cleaning fluids. During a cleaning cycle when the vaporizer is being flushed, cleaning fluid flows from reservoir **115** through conduit **114** to three-way valve **113**, which is in the open position, and thence into the vaporizer **117**, where it is caused to bathe the vaporization structure and thus clean it of any solid or liquid build-up.

During the cleaning process valve **124** may be opened or closed depending on the specific pressure and flow conditions required by the cleaning process and depending on any need for extended contact times for the cleaning fluid to dissolve buildup.

If valve **124** is closed for an appropriate time to allow the cleaning fluid to dissolve any build-up on the vaporizer structure, it is then opened, and the used cleaning fluid flows out of the vaporizer through conduit **123**, on-off valve **124**, which is now in the open position, and through conduit **125**.

Alternatively, valve **124** is left open for the entire period that cleaning fluids are introduced to the vaporizer **117**, and the used cleaning fluids continuously flow through conduit **23** and valve **124** and into conduit **125** during the cleaning process.

During cleaning cycles, on-off valve **119** is in the closed position to prevent cleaning by-products flowing to the CVD reactor vessel **122**. On-off valve **29** may be open or closed depending on the nature of any parallel process being run in the CVD chamber **22**. Vapors will continue to flow through conduit **33** into the scrubber or trap **30**, but liquids will flow by gravity through conduit **26**, on-off valve **34** which is in the open position, and into liquid collection reservoir **27**.

The purpose of the bypass provided by **33** is to prolong the lifetime or extend the time between changeouts or regenerations of the scrubber or trap **30**, by collecting the liquids, which consist mostly of spent cleaning solution, before they can flow into the scrubber or trap. On-off valve **34** enables removal and emptying of liquid collection reservoir **27** without complications.

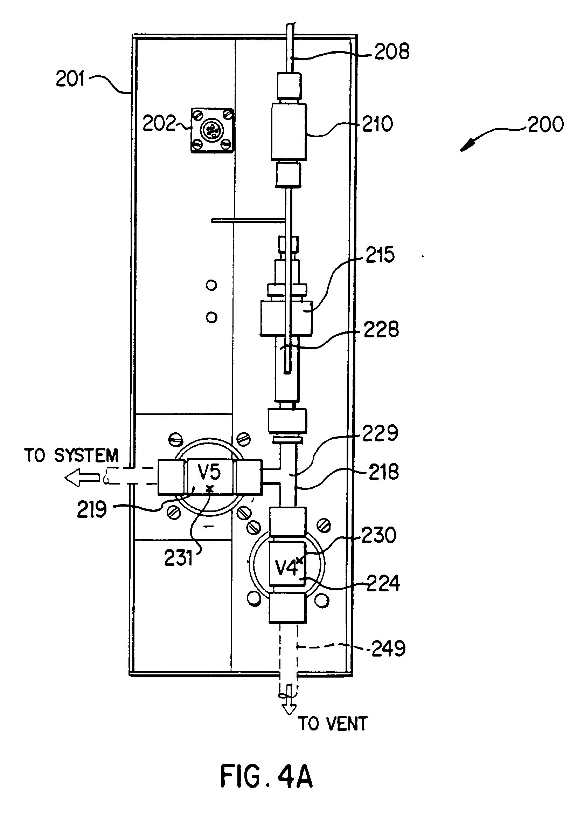

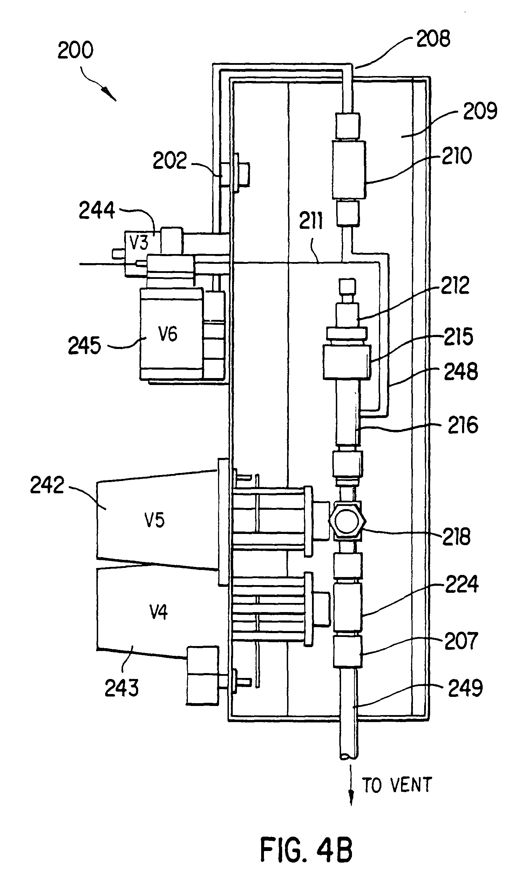

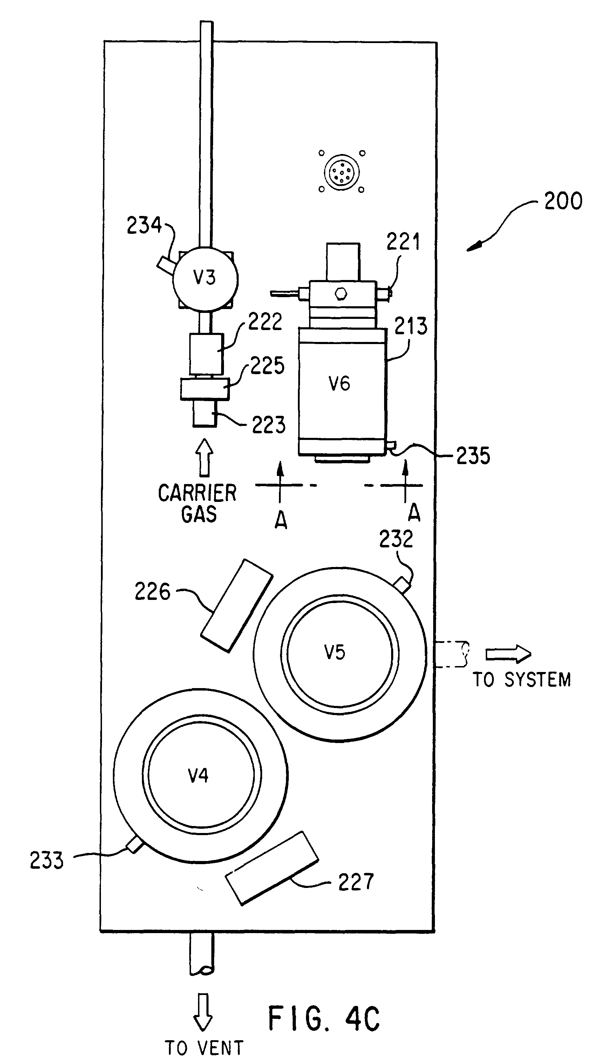

Figures 4a, 4b and 4c are cutaway views from three angles successively rotated 90° of a vaporizer assembly **200** incorporating the cleaning subassembly of the present invention. The view of Figure 4b is rotated 90° about the vertical axis from Figure 4a. The view of Figure 4c is rotated 180° about the vertical axis from Figure 4a. These drawings were used in the construction of a functional vaporizer assembly with self-cleaning capability. The assembly is mounted in casing **201**.

In the film deposition mode, on-off valve **219** is open, on-off valve **224** is closed, and three-way valve **213** is opened for reagent flow to the vaporizer and closed to cleaning fluid flow to the vaporizer.

Source reagent liquid or solution flows in through line **211** via the vaporizer element housings **212** and **215** to the vaporization zone **216**. Carrier gas flows in through valve fittings **222** and **223** and check valve **225** through conduit **208** and thence through particle filter **210**, which may advantageously be used also as a gas pre-heat zone, because of the particle filter's high surface area.

The filtered carrier gas flows then flows through conduit **248** and is introduced to vaporization zone **216**, where it mixes with the source reagent. Downstream of vaporization zone **216**, the carrier gas laden with vapor phase source reagent flows into the reactor through valve **219** which is open.

In the vaporizer cleaning mode, three-way valve **213** is opened to cleaning fluid flow to the vaporizer, and is closed to reagent flow. On-off valve **219** is closed, isolating the CVD reactor from the vaporizer cleaning process.

During cleaning, on-off valve **224** may either be opened or may be initially closed and then opened for flow of used cleaning fluid to a fluid collection reservoir or gas trap (not shown), depending on the flow and pressure requirements of the cleaning process.

Cleaning fluid flows in via cleaning fluid port **221** through line **211** via the vaporizer element housings **212** and **215** to the vaporization zone **216**.
Used cleaning fluid flows out of the vaporization zone via valve **224**, fitting **207**, and conduit **249** to a fluid collection reservoir or gas trap (not shown).

During both deposition and cleaning modes, the temperature of the vaporizer assembly is controlled. Power plug and thermocouple connections are provided through connector **202**, which provides power to heater blanket **209**. Heating is controlled in four zones, which are monitored by thermocouples **228** (measures temperature of the vaporization zone **216**), **229** (measures temperature of the run/vent junction **218**), **230** (measures temperature of the vent valve **224**), and **231** (measures temperature of the valve **219** leading to the reactor chamber). Independent control of these zones provides for the fine tuning required to provide process stability and reproducibility.

In this illustrative apparatus, the valves are controlled pneumatically, although other modes of control such as manual or electromechanical are also possible. Pneumatic control connections **232, 233, 234**, and **235** and pneumatic valve actuators **242, 243, 244** and **245** to valves **219, 224, 225** and **213** respectively are provided. Valve status indicators **226** and **227** show the positions of valves **219** and **224** respectively. The control of the valves may be manual, by timer, or may be driven by a programmable logic device which is capable of responding to signals from process variable sensors.

The invention is also applicable to conventional vaporizers in which the chemical vapor deposition reagent reservoir (or "bubbler") is itself the vaporizer, and hence the generation and accumulation of involatile compounds proceeds by the same mechanisms as described above for vaporizers of compounds that are remotely delivered by a pump as-needed in the process.

The invention may in addition comprise sensing means or a timer mechanism to determine the frequency of the cleaning cycles. Such a sensing mechanism could detect a pressure differential across the vaporizer, the fluid conductance through the vaporizer, light reflectance off the vaporizer structure which would be altered by the build up of solids, radial thermal conductance of the vaporizer, or feedback from the properties of the growing films. All such measurable properties could be used to provide an indication that the vaporizer's performance was deteriorating and it needed to be cleaned. Alternatively, in well-characterized deposition systems, the cleaning cycles could be triggered by a timer. Such an approach has the advantage of simplicity and predictability.

The vaporizer cleaning method of the present invention may optionally include a liquid collection reservoir as shown in Figure 3. This liquid collection reservoir provides a number of practical advantages. The lifetime or time between changeouts or regenerations of the scrubber or cold trap may be extended.

Alternatively, the liquid being collected may be recycled and reused as cleaning fluid or if the source reagent is a highly valuable solid compound that is being deposited prematurely on the vaporizer, it can be repurified and reused. If the source reagent is toxic, as are barium or thallium compounds for example, the collected liquid contaminated by the toxic substance can provide a more concentrated and easier-to-handle form of the hazardous waste for disposal purposes than would the spent scrubber or more dilute trap residue if the fluid were allowed to flow further into the scrubber or trap **132**.

In cases where the liquid is contaminated by toxic reagents that may be hazardous to handle, it may be desirable to incorporate a scavenging medium into the liquid collection reservoir, such as a solid, porous chemisorbent, to increase the safety of the personnel responsible for running the reactor. If the cleaning fluid is a strong acid, it may be desirable to neutralize or immobilize it in situ, again for the purpose of enhancing safety. It may also be desirable to control the temperature of the liquid reservoir so that it functions to some degree as a cold trap.

The cleaning fluid is selected on the basis of several criteria, which include the following:
1) The fluid should dissolve the CVD source and decomposition products or should react with them to form soluble products.
2) To protect the integrity of the process, the fluid should be free of particles.
3) The fluid should have a high vapor pressure (>266,6 Pa (200 torr) at room temperature).

As guidance for selection of an appropriate fluid, it should be kept in mind that in many cases deposits that occur on the vaporizer will be chemically very similar to the film being grown in the process. If barium titanate is being grown, there is likely to be largely barium titanate being deposited on the vaporizer. The appropriate fluid could therefore be selected on the basis of being a good etchant for barium titanate. On the other hand, if the source reagent is quite involatile, such as Ba(thd)₂, the deposits are likely to be mostly unreacted source reagent, and the organic solvent that the reagent is dissolved in will be a good choice as a cleaning fluid.

Solid reagents such as those described in U.S. Patent Application Serial No. 07/807,807, "Method for Delivering an Involatile Reagent in Vapor Form to a CVD Reactor" are customarily dissolved in a low-boiling alcohol or ether solvent such as isopropanol or tetrahydrofuran or isopropanol/tetrahydrofuran mixtures. The added low volatility liquid can advantageously be a polyether such as tetraglyme (tetraethylene glycol dimethyl ether, boiling point ~275°C) or triglyme (triethylene glycol dimethyl ether, boiling point ~216°C). Polyamines such as tetraethylenepentamine (boiling point 340°) or triethylenetetramine (boiling point 266-267°C) could also be selected. These low volatility liquids are soluble in the alcohol or ether solvent and also dissolve the solid reagents. For example, when the solvent is isopropanol or an isopropanol/tetrahydrofuran mixture and the solid reagent is a metal beta-diketonate complex, tetraglyme has been shown to be effective as the low volatility liquid. A typical solution is exemplified by 0.1M barium(thd)₂ (bis(2,2,6,6-tetramethyl-3,5-heptanedionato)barium) dissolved in 9:1 isopropanol:tetraglyme.

In some cases the cleaning fluid should be a vapor, such as the use of HF to clean deposits of oxides such as tantalum oxide. In some situations it may be necessary to include the capability to flow more than one cleaning fluid onto the vaporization structure. Such a requirement would necessitate the inclusion of one or more additional cleaning fluid reservoirs as well as associated conduits and valves. It may also be desirable to include the capability to flow the cleaning fluid at elevated or reduced pressures. If the built up material being dissolved off of the vaporization structure is likely to reprecipitate, it may be necessary to heat the conduit from the vaporizer to the liquid collection reservoir.

As part of the cleaning cycle, one or more steps may be incorporated wherein the vaporizer is heated to an elevated temperature to assist in the dissolution of solid buildup.

In order to run a continuous process, two vaporizers can be provided with automatic switching and run in parallel so that as one vaporizer is being cleaned and brought back into thermal equilibrium the other one is being used to run the CVD process.

Physical assistance may be provided to the cleaning process, consistent with process integrity. As long as minimal numbers of particles are generated and transferred into the CVD reactor, plasma or ultrasound may be used to enhance the ability of the cleaning fluid to remove solid buildup from the vaporizer.

Materials of construction of the vaporizer and the associated piping and valving must be consistent with the requirements of the process as to particle generation and other contamination issues and must be resistant to corrosion by the liquids and/or vapors being used as cleaning fluids or solvents for solid source reagents. Stainless steel is preferred.

Many possible configurations of piping and valving may be used to accomplish the present invention, as indeed many possible cleaning fluids may be selected.

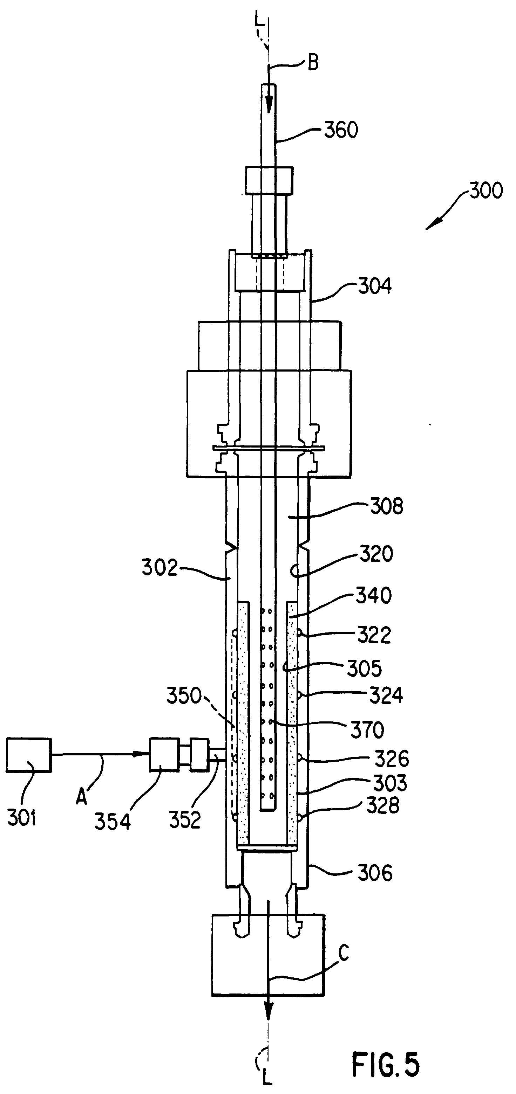

Figure 5 is a schematic illustration of a vaporization apparatus **300** according to another embodiment of the invention.

The vaporization system **300** may be usefully employed for vaporization, and specifically flash vaporization, of a wide variety of liquid reagents which require delivery in vapor form to a locus of use.

The apparatus comprises a housing **302** which as shown may be of generally elongate cylindrical shape. The housing **302** defines a vaporization chamber with respective upper and lower ends **304** and **306**.

The vaporization chamber thus includes an interior volume **308** therewithin which is at least partially bounded by an enclosing interior wall surface **320** of the housing.

The interior wall surface **320** features a series of longitudinally spaced-apart channels or grooves **322, 342, 326** and **328** therein, each of which is substantially perpendicular to the longitudinal axis L-L of the housing and vaporization chamber comprising such housing. Each of the channels or grooves **322, 324, 326**, and **328** may be suitably formed by scribing or otherwise forming a concave involution in the wall surface **320**. Each of the channels or grooves thus provides a branch liquid flow passage joined in liquid flow communication for, with manifold channel **350**. As shown the manifold channel 350 may be substantially parallel in orientation with respect to the longitudinal central axis L-L of the housing and the vaporization chamber. The manifold channel **350** thus serves as a feed trough for liquid which is delivered to the vaporization chamber by means of conduit **352**. Conduit **352** has coupling fitting **354** at its outer extremity, for joining to a liquid feed line for supply of liquid source reagent from source vessel **301**. The source reagent liquid thus flows in the direction indicated by arrow A into the conduit **352** which is joined in liquid flow communication with manifold channel **350**, from which the liquid is distributed to the respective channel branches **322, 324, 326** and **328**. In this manner, the liquid is distributed over the contiguous surface **303** of porous vaporization element **340**, which may be formed of a sintered metal material, porous ceramic media, or other suitable material of construction. Thus, the vaporization element in this embodiment is disposed in the vaporization chamber and has an outer wall surface **303** in contiguous relationship to the enclosing interior wall surface **320** of the housing. The porous vaporization element **340** has an inner wall surface **305** which is presented to the interior volume **308** of the vaporization chamber.

By this arrangement, liquid fed into the branch channels contacts the outer surface **303** of the porous vaporization element **340**, which is heated to a temperature suitable for vaporization of the source reagent liquid (by means not shown in Figure 5), so that source reagent liquid thereby is vaporized. The resulting vapor transfuses through the porous wall of the vaporization element to the inner surface of the vaporization element, from which it passes into the interior volume **308** for discharge at the lower outlet end **306** of the chamber, in the direction indicated by arrow C, and is transferred to a downstream sub-system of the process system. The downstream locus of use may for example comprise a chemical vapor deposition reactor, in which a substrate is deposited with a material derived from the vapor discharged from the vaporization apparatus.

In some embodiments of the system shown in Figure 5, it may be desirable to introduce to the interior volume **308** of the vaporization chamber a suitable carrier gas, and for such purpose the upper end **304** of the vaporization chamber is provided with an introduction conduit **360** through which carrier gas can be flowed, in the direction indicated by arrow B, for mixing with the vaporized reagent entering the interior volume **308** through the porous wall member of the vaporization element **340**.

It will be recognized that in some applications, it will be desired to discharge from the vaporization chamber only the vaporized reagent, free of any carrier gas or other gas or vapor components mixed therewith, and in such instance, the carrier gas feed conduit **360** may be omitted from the apparatus, or otherwise provided with a suitable valve or other flow restriction means to close the interior volume of the chamber to any carrier gas feed introduction.

It is seen from the schematic depiction in Figure 5 that the porous vaporization element **340** comprises a porous wall member having an outer wall surface which together with the grooves or channels in the vaporization chamber wall provides a flow channel arrangement which distributes the source reagent liquid over the outer wall surface of the vaporization element. It will be recognized that the flow channel arrangement may be widely varied, and that in some instances, it may be desirable to have a series of grooves or channels parallel to the central axis L-L of the vaporization chamber, which are circumferentially spaced-apart about the periphery of the inner wall surface of the vaporization chamber, and which are interconnected by one or more connecting feed troughs, such as channel **326** in the Figure 5 embodiment.

It may also be possible to knurl or texturize the inner wall surface of the vaporization chamber, in relation to the porous vaporization element in contact therewith, to effect distribution of liquid over the vaporization wall member surface via capillary action, gravitational flow, and/or other hydrodynamic phenomena, whereby the vaporization operation is carried out most efficaciously.

It will likewise be appreciated that the porous wall member **340** may itself be variously formed, e.g., with an undulant or grooved surface which cooperates with channels formed in the wall of the vaporization chamber, to accommodate liquid distribution for vaporization thereof.

It will also be appreciated that the vaporization apparatus could be fabricated with a vaporization chamber wall surface devoid of any channel or passage means therein, and with the porous wall member or other vaporization element constructed so as to form a liquid channel in cooperation with the housing wall in proximity thereto.

It may also be feasible in some instances to space the porous wall member in relation to the vaporization chamber wall surface, such as by means of a collar or spacer element which provides an enclosed liquid distribution volume, so that the liquid can enter such plenum space between the outer surface of the porous wall member and the inner wall surface of the vaporization chamber housing, and be readily vaporized.

It will therefore be appreciated that the configuration of the vaporization chamber and vaporization element associated therewith may be widely varied, within the broad practice of the present invention.

The following non-limiting examples describe modes of use of the present invention.

### EXAMPLE 1

Use of a dual piston metering pump as depicted schematically in the Figures to deliver the reagent tantalum pentaethoxide, a moisture-sensitive liquid, caused a build-up of tantalum oxide on the pistons after tens of hours, which eroded the piston seals and stopped any piston movement. When dry nitrogen was purged around the wetted parts of the pump, no visible build-up of tantalum oxide was observed after tens of hours of use, and pump operation continued smoothly.

### EXAMPLE 2

The dual piston metering pump equipped with the purge mechanism was used for delivery of 54 ml (50.2 g) of tetrakis(dimethylamido)titanium reagent. This titanium reagent is extremely air- and moisture-sensitive, decomposing in air to dimethylamine and solid titanium oxides and/or hydroxides over the space of a few minutes. The purged dual piston pump was loaded with tetrakis(dimethylamido)titanium for seven weeks and used to deliver the reagent for greater than 20 hours with no detectable deterioration in the pump seals and no visible build-up of solid decomposition products on the wetted parts.

It will be recognized that the identity of the inert (purge blanket) medium and the materials of construction of the chamber and pump parts may be varied widely, in accordance with the disclosure of the invention described herein.

### EXAMPLE 3

The in-situ cleaning method of the instant invention was used in a chemical vapor deposition process for depositing Ba_{0.70}Sr_{0.30}TiO₃ films for use as capacitors in microelectronic integrated circuits (IC's). In one experiment, Ba(thd)₂ (0.14 M), Sr(thd)₂ (0.06 M) and Ti(O-Pr)₂(thd)₂ (0.15 M) were dissolved in a solvent constituting a 9:1 mixture of isopropanol:tetraglyme (by volume) and delivered to a vaporizer (230°C) at 4 ml/hr for 12.5 hours.

Following the deposition, brown liquid and solid residue were observed in the proximity of the vaporization zone, and approximately 13% of the Ba introduced to the vaporizer was found there. Sr and Ti were delivered to the reactor somewhat more efficiently, with 9% and 1% of those elemental species left near the vaporizer as involatile residue.

To correct this problem, the vaporizer was flushed using an apparatus such as is depicted schematically in Figure 3. A solvent was used (isopropanol in this specific case) that was effective in dissolving (and subsequently vaporizing) residual metalorganic-containing solution from inlet plumbing in the vaporizer in addition to redistributing residual metalorganic compounds in the vaporizer in such a way that they flowed into the trap either as gases or as liquids whose flow is driven by gravity.

### EXAMPLE 4

Tantalum oxide, Ta₂O₅, is seeing expanded use in the microelectronics industry as a promising dielectric for storage capacitors in scaled down memory cells and as a gate insulator of metal-oxide-semiconductor devices. The preferred precursor for chemical vapor deposition of Ta₂O₅ is tantalum ethoxide [Ta(OCH₂CH₃)₅], a liquid with a vapor pressure of 0.1 torr at 150°C.

The conversion of the liquid reagent to vapor was accomplished by a technique described in U.S. Patent No. 5,204,314, "Method For Delivering an Involatile Reagent in Vapor Form to a CVD Reactor."

Tantalum ethoxide was delivered to a vaporization zone using a dual piston metering pump at rates of 0.01 to 0.20 ml/min. The vaporization temperatures were varied from 165°C to 185°C and a carrier gas flow rate of 50 sccm was used. The pressures in the vaporization zone were 0.1 to 10 torr. Build-up of solid tantalum oxide or sub-oxides on the vaporization surface was observed after tens of minutes.

To address this problem, the oxide is cleaned off the vaporization surface by dissolution in aqueous hydrofluoric acid. The acid is introduced along the same pathway as the tantalum ethoxide via the three-way valve **113** as shown in Figure 3. The solution containing the tantalum reagent decomposition products is gravity fed into the liquid collection reservoir. The surface of the vaporizer is dried under a stream of inert gas before further tantalum ethoxide is introduced onto it.

### EXAMPLE 5

Titanium nitride, TiN, is a material of interest for diffusion barrier layers in silicon electronics. One precursor of interest for the MOCVD of TiN is tetrakis(diethylamido)titanium [Ti(N(CH₂CH₃)₂)₄].

The conversion of the liquid reagent to vapor was accomplished by a technique described in U.S. Patent No. 5,204,314, "Method For Delivering an Involatile Reagent in Vapor Form to a CVD Reactor."

A dual piston metering pump was used for delivery of 54 ml (50.2 g) of the TiN reagent. The reagent was vaporized at temperatures between 150 to 165°C and the vapor recondensed and collected. 51 ml (47.4g) of reagent was collected, the remaining material having been decomposed in the vaporization zone by either thermal decomposition or by reaction with atmospheric contaminants in the vaporization zone. The titanium reagent is extremely air- and moisture-sensitive, decomposing in air to dimethylamine and solid titanium oxides and/or hydroxides over the space of a few minutes.

To deal with the resulting build-up of titanium oxides on the vaporization structure, aqueous hydrofluoric acid is introduced into the vaporization zone and passed over the surface of the vaporization element. The solubility of the titanium decomposition products in the acid allows the surface to be cleaned and the solution of decomposition products to be collected as a liquid. The cleaned area is then heated to >100°C under vacuum to remove any residual water. The titanium nitride source reagent may then be introduced into the cleaned vaporization zone and delivered as vapor to the CVD reactor chamber.

It will be recognized that the details of the various parts of the cleaning system may vary widely. These constituent parts include: the cleaning liquid pump, the multiple position valve, the vaporizer configuration (including ports in it for introduction and removal of liquids and gases) , the valves downstream of the vaporizer and the liquid and solid traps, which are shown as a single element in Figure 3.

While the invention has been described herein with reference to specific aspects, features, and embodiments, it will be apparent that other variations, modifications, and embodiments are possible, and all such variations, modifications, and embodiments therefore are to be regarded as being within the scope of the invention.

## Claims

1. An apparatus for vaporizing a source reagent of non-vapor character, to produce a vapor for transport to a locus of use, said apparatus comprising ;
a vaporization chamber including a housing defining therewithin an enclosed interior vaporization volume;
means for feeding source reagent to the interior volume of the housing;
vaporization means disposed within the interior volume of said housing and in receiving relationship to the feed means, for receiving source reagent and effecting vaporization thereof; and
means for selectively feeding to the interior volume, for contact with the vaporization means and interior surfaces of the housing, a cleaning fluid which is cleaningly effective to at least partially remove vaporization deposits from said vaporization means and interior surfaces of the housing;
characterised in that the vaporization chamber has a liquid flow passage formed on an enclosing interior wall surface thereof;
the vaporization means comprises at least one porous wall member having inner and outer wall member surfaces, wherein said porous wall member is positioned with the outer wall member surface thereof in proximate relationship to the enclosing interior wall surface of the vaporization chamber having said liquid flow passage formed thereon, so that the outer wall member surface of the porous wall member overlies said liquid flow passage, and so that the inner wall member surface of the porous wall member is presented to the interior volume of the vaporization chamber;
means are provided for heating the porous wall member to a temperature for vaporization of the vaporizable liquid; and
the means for feeding source reagent to the interior volume of the housing deliver vaporizable liquid to the liquid flow passage for contact with the porous wall member heated to said temperature for vaporization of the vaporizable liquid, so that resulting vapor formed by said contact passes through said porous wall member to the interior volume of the vaporization chamber.

2. The apparatus of claim 1 characterized by a vaporization chamber of cylindrical shape.

3. The apparatus as claimed in claims 1 or 2 characterized in that the vaporization chamber is of cylindrical shape, the porous wall member is of cylindrical shape, and the outer wall member surface of the porous wall member is in contiguous relationship to the enclosing interior wall surface of the vaporization chamber over the entire areal extent of the outer wall member surface of the porous wall member.

4. The apparatus as claimed in any of claims 1 to 3 characterized in that the porous wall member is formed of a material selected from sintered metal materials and porous ceramic materials.

5. The apparatus as claimed in any of claims 1 to 4 characterized in that the enclosing interior wall surface liquid flow passage comprises at least one manifold liquid flow passage joined in liquid flow communication with plural liquid flow passage branches.

6. The apparatus as claimed in claim 5 characterized in that the vaporization chamber and porous wall member are in coaxial relationship to each other, and are of elongate character with a common longitudinal central axis, with said manifold liquid flow passage extending linearly and parallelly to said longitudinal central axis, and with said plural liquid flow passage branches being perpendicular to said longitudinal central axis.

7. The apparatus as claimed in any of claims 1 to 6 which further comprises means for introducing carrier gas into said interior volume of said vaporization chamber to form a gas mixture comprising said carrier gas and said resulting vapor therein during operation of said apparatus.

8. The apparatus as claimed in any of claims 1 to 7 characterized in that said means for introducing carrier gas into said interior volume of said vaporization chamber comprise an elongate perforate gas delivery tube in said interior volume joined in gas flow communication with a source of carrier gas exterior of the vaporization chamber.

9. The apparatus as claimed in any of claims 1 to 8 characterized in that the means for feeding source reagent to the interior volume of the housing comprises a pump, wherein said pump includes:
a pump block with an interior pumping cavity;
a piston positioned in the pumping cavity for reciprocatable movement therein;
a first liquid seal mounted in the pumping cavity and circumscribingly arranged about the piston (i) to effect sealing between the piston and the pumping cavity during reciprocating movement of the piston in the cavity, and (ii) to bound an inner liquid pumping volume of the pumping cavity;
a second fluid seal mounted in the pumping cavity and circumscribingly arranged about the piston to effect sealing between the piston and the pumping cavity during reciprocating movement of the piston in the cavity, the second fluid seal being in spaced-apart relationship to the first liquid seal to define an intraseal volume of the pumping cavity therebetween;
an inlet liquid passage joined to the inner liquid pumping volume for introduction of feed liquid thereto;
an outlet liquid passage joined to the inner liquid pumping volume for discharging of pressurized liquid therefrom:
a fluid inlet passage joined to the intraseal volume of the pumping cavity for introduction of a purge gas or liquid thereto; and
a fluid outlet passage joined to the intraseal volume of the pumping cavity for discharging of purge gas or liquid therefrom,
whereby a portion of the piston during reciprocating movement thereof is translated between the liquid pumping volume of the pumping cavity and the intraseal volume of the pumping cavity.

10. The apparatus as in claim 9 characterized in that the feed liquid supply means is joined in liquid supply relationship to the liquid inlet passage.

11. The apparatus as claimed in claim 9 or 10 characterized in that the purge fluid supply means is joined in fluid supply relationship to the fluid inlet passage.

12. The apparatus as claimed in any of claims 9 to 11 characterized in that the pump block comprises a unitary machined metal block.

13. The use of an apparatus of claim 9 for carrying out a process for inhibiting corrosion and/or particulate formation in said pump, characterised by said pump being adapted for pumping of a liquid mediating said corrosion and/or particulate formation in the presence of oxygen and/or other atmospheric gases, wherein the reciprocating piston is reciprocatable between a first extended position in the pumping cavity of the pump and a second retracted position exterior of the pumping cavity, so that an active pumping portion of the reciprocating piston sequentially and repetitively contacts liquid in the liquid pumping chamber and then is withdrawn exteriorly of the liquid pumping chamber, wherein the active pumping portion of the reciprocating piston exterior of the liquid pumping chamber is blanketed with an inert fluid, so that the active pumping portion of the reciprocating piston is prevented from contacting oxygen or other atmospheric gases.

14. Use as claimed in claim 13, wherein the inert fluid is selected from argon, nitrogen, helium and hydrogen.

15. Use as claimed in claim 13 or 14 which further comprises reciprocating the piston in the pumping cavity ; flowing feed liquid through the inlet liquid passage to the pumping cavity ; discharging pressurized liquid from the pumping cavity through the outlet liquid passage ; flowing purge fluid through the fluid inlet passage into the intraseal volume of the pumping cavity ; and discharging purge fluid from the intraseal volume of the pumping cavity through the fluid outlet passage.

16. Use as claimed in claim 13 or 14 wherein said process comprises admixing the process liquid with a low vapor pressure liquid component which is solvatingly effective for inhibiting corrosion or particulate formation, in an amount effective for said inhibition.

17. Use as claimed in claim 16 wherein the low vapor pressure liquid is selected from polyethers, polyamines, and aromatic amines.

18. Use as claimed in claim 16 wherein the low vapor pressure liquid is selected from tetraglyme, triglyme, diglyme, tetraethylenepentamine, and triethylenetetramine.

19. Use as claimed in any of claims 16 to 18 wherein the process liquid is a solution of a metal beta-diketonate complex in a low-boiling solvent, and the low vapor pressure liquid is selected from tetraglyme, triglyme, or diglyme.

20. The use of an apparatus of claim 9 for carrying out a process for inhibiting corrosion and/or particulate formation in the pump, characterised by at least one of the steps of:
admixing the process liquid with a low vapor pressure liquid component which is solvatingly effective for inhibiting corrosion or particulate formation in an amount effective for said inhibition; and
blanketing the piston exterior of the pumping cavity with an inert fluid, so that the active pumping portion of the reciprocating piston is prevented from contacting oxygen or other atmospheric gases.

21. An apparatus for vaporizing a source reagent of non-vapor character, to produce a vapor for transport to a locus of use, said apparatus comprising: a vaporization chamber including a housing defining therewithin an enclosed interior vaporization volume; means for feeding source reagent to the interior volume of the housing; vaporization means disposed within the interior volume of said housing and in receiving relationship to the feed means, for receiving source reagent and effecting vaporization thereof; characterised by means for selectively feeding to the interior volume, for contact with the vaporization means and interior surfaces of the housing, a cleaning fluid which is cleaningly effective to at least partially remove vaporization deposits from said vaporization means and interior surfaces of the housing being joined in vaporized reagent flow relationship to a downstream deposition chamber, and the flow of cleaning fluid, source reagent, and vaporized reagent are selectively controlled with flow control means of a selectively actuatable character the flow control means being interconnected with a cycle timer means, to produce a sequence of vaporization of source reagent and delivery of same to the downstream deposition chamber for a predetermined first portion of the cycle, followed by cessation of flow of source reagent and vaporized reagent, and flow of cleaning fluid into the chamber for cleaning thereof and the cycle timer means comprising means for sensing a system variable selected from the group consisting of: a pressure differential across the vaporizer; the fluid conductance through the vaporizer; light reflectance off the vaporizer structure at a wavelength where such reflectance is altered by the build up of solids; the radial thermal conductance of the vaporizer; and feedback from the properties of the growing films.

22. A method of vaporizing a non-vapor source reagent, and at least partially removing deposition by-products of such vaporization, said process comprising:
providing an apparatus for vaporizing a source reagent of non vapor character, to produce a vapor for transport to a locus of use, said apparatus comprising:
a vaporization chamber including a housing defining therewithin an enclosed interior vaporization volume;
means for feeding source reagent to the interior volume of the housing:
vaporization means disposed within the interior volume of said housing and in receiving relationship to the feed means, for receiving source reagent and effecting vaporization thereof; and
vaporizing the source reagent in the housing for a predetermined time, and flowing resulting vaporized reagent out of the housing;
characterised by :
said apparatus including means for selectively feeding to the interior volume, for contact with the vaporization means and interior surfaces of the housing, a cleaning fluid which is cleaningly effective to at least partially remove vaporization deposits from said vaporization means and interior surfaces of the housing; and
after said predetermined time, terminating flow of source reagent and vaporized reagent, and flowing into said housing a cleaning fluid which is cleaningly effective for at least partial removal of deposits produces by said vaporization.

23. The method as claimed in claim 22 further comprising the steps of passing the vaporized reagent flowed out of the housing to a chemical vapor deposition zone, and effecting chemical vapour deposition from the vaporized reagent in said zone.

24. The method as claimed in claims 22 or 23 wherein the cleaning fluid comprises organic solvent.

25. The method as claimed in claim 24 wherein the cleaning fluid is selected from at least one of the following, alcohols, ethers, polyethers, polyamines, or mixtures thereof.

26. The method as claimed in claim 24 wherein the cleaning fluid comprises a polyamine.

27. The method as claimed in claim 22 wherein the cleaning fluid comprises hydrogen fluoride.

28. The method as claimed in claim 22 wherein the cleaning fluid comprises tetrahydrofuran.

29. The method as claimed in claim 22 wherein the cleaning fluid comprises a solvent of a type present in source reagent.

30. The method as claimed in claim 22 wherein the housing is joined in vaporized reagent flow relationship to a downstream deposition chamber, and wherein the flow of cleaning fluid, source reagent and vaporized reagent are selectively controlled with the flow control means of a selectively actuatable character.

31. The method as claimed in claim 22 wherein the flow control means are interconnected with cycle timer means to produce a sequence of vaporization of source reagent and delivery of same to the downstream deposition chamber for a predetermined first portion of the cycle, followed by cessation of flow of source reagent and vaporized reagent, and flow of cleaning fluid into the chamber for cleaning thereof.

32. A chemical vapor deposition system, comprising:
an apparatus for vaporising a vaporizable liquid, comprising:
a vaporization chamber including an interior volume therewithin and at least partially bounded by an enclosing interior wall surface;
a vaporization element disposed in said vaporization chamber;
means for heating the vaporization element to a temperature for vaporization of the vaporizable liquid;
means for delivering vaporizable liquid to the vaporization element including a pump assembly; and
means for discharging vapor from the interior volume of the vaporization chamber;
characterised by:
(A) said enclosing interior wall surface having a liquid flow passage formed thereon;
(B) said vaporization element comprising at least one porous wail member having inner and outer wall member surfaces, wherein said porous wall member is positioned with the outer wall member surface thereof in proximate relationship to the enclosing interior wall surface to cooperatively therewith form said liquid flow passage, so that the outer wall member surface of the porous wall member overlies said liquid flow passage, and so that the inner wall member surface of the porous wall member is presented to the interior volume of the vaporization chamber;
(C) said pumping assembly comprising:
a pump block with an interior pumping cavity;
a piston positioned in the pumping cavity for reciprocatable movement therein;
a first liquid seal mounted in the pumping cavity and circumscribingly arranged about the piston (i) to effect sealing between the piston and the pumping cavity during reciprocating movement of the piston in the cavity, and (ii) to bound an inner liquid pumping volume of the pumping cavity;
a second fluid seal mounted in the pumping cavity and circumscribingly arranged about the piston to effect sealing between the piston and the pumping cavity during reciprocating movement of the piston in the cavity, the second fluid seal being in spaced-apart relationship to the first liquid seal to define an intraseal volume of the pumping cavity therebetween;
an inlet liquid passage joined to the inner liquid pumping volume for introduction of feed liquid thereto;
an outlet liquid passage joined to the inner liquid pumping volume for discharging of pressurized liquid therefrom;
a fluid inlet passage joined to the intraseal volume of the pumping cavity for introduction of a purge gas or liquid thereto; and
a fluid outlet passage joined to the intraseal volume of the pumping cavity for discharging of purge gas or liquid therefrom,
whereby a portion of the piston during reciprocating movement thereof is translated, between the liquid pumping volume of the pumping cavity and the intraseal volume of the pumping cavity; and
(D) means for selectively feeding to the interior volume, for contact with the vaporization element and interior surfaces of the housing, a cleaning fluid which is cleaningly effective to at least partially remove vaporization deposits from said vaporization element and interior surfaces of the housing.

## Patentansprüche

1. Vorrichtung zum Verdampfen eines Ausgangsreagenzes nicht-dampfförmiger Natur zur Erzeugung eines Dampfes zum Transport zu einem Anwendungsort, die umfasst:
eine Verdampfungskammer, umfassend ein Gehäuse, das darin ein abgeschlossenes inneres Verdampfungsvolumen definiert;
Mittel zum Zuführen des Ausgangsreagenzes in das innere Volumen des Gehäuses;
Verdampfungsmittel, die im inneren Volumen des Gehäuses und in aufnehmender Beziehung zu den Zuführungsmitteln angeordnet sind, um das Ausgangsreagenz aufzunehmen und dessen Verdampfung zu bewirken; und
Mittel zur selektiven Zuführung in das innere Volumen zum Kontakt mit den Verdampfungsmitteln und inneren Oberflächen des Gehäuses eines Reinigungsfluids, das reinigend wirksam ist, um Verdampfungsabscheidungen wenigstens teilweise von den Verdampfungsmitteln und den inneren Oberflächen des Gehäuses zu entfernen;
dadurch gekennzeichnet, dass die Verdampfungskammer einen an einer einschließenden inneren Wandoberfläche davon ausgebildeten Flüssigkeitsstromdurchlass besitzt;
die Verdampfungsmittel mindestens ein poröses Wandelement mit inneren und äußeren Wandeiementoberflächen besitzen, wobei das poröse Wandelement mit der äußeren Wandelementoberfläche davon in naher Beziehung zu der einschließenden inneren Wandoberfläche der Verdampfungskammer, die den Flüssigkeitsstromdurchlass darauf ausgebildet hat, angeordnet ist, so dass die äußere Wandelementoberfläche des porösen Wandelements über dem Flüssigkeitsstromdurchlass liegt und so dass die innere Wandelementoberfläche des porösen Wandelements dem inneren Volumen der Verdampfungskammer dargeboten ist;
Mittel zum Erhitzen des porösen Wandelements auf eine Temperatur zur Verdampfung der verdampfbaren Flüssigkeit angeordnet sind; und
die Mittel zur Zuführung des Ausgangsreagenzes zu dem inneren Volumen des Gehäuses verdampfbare Flüssigkeit zu dem Flüssigkeitsstromdurchlass befördern zum Kontakt mit dem auf die Temperatur zur Verdampfung der verdampfbaren Flüssigkeit erhitzten Wandelement, so dass der durch den Kontakt gebildete resultierende Dampf durch das poröse Wandelement hindurch in das innere Volumen der Verdampfungskammer tritt.

2. Vorrichtung nach Anspruch 1, gekennzeichnet durch eine Verdampfungskammer von zylindrischer Form.

3. Vorrichtung nach Anspruch 1 oder 2, dadurch gekennzeichnet, dass die Verdampfungskammer von zylindrischer Form ist, das poröse Wandelement von zylindrischer Form ist und die äußere Wandelementoberfläche des porösen Wandelements über die gesamte Flächenausdehnung der äußeren Wandelementoberfläche des porösen Wandelements in angrenzender Beziehung zu der einschließenden inneren Wandoberfläche der Verdampfungskammer steht.

4. Vorrichtung nach einem der Ansprüche 1 bis 3, dadurch gekennzeichnet, dass das poröse Wandelement aus einem Material, ausgewählt aus gesintertem Metallmaterial und porösem keramischem Material, gebildet ist.

5. Vorrichtung nach einem der Ansprüche 1 bis 4, dadurch gekennzeichnet, dass der Flüssigkeitsstromdurchlass an der einschließenden inneren Wandoberfläche mindestens einen Mehrfach-Flüssigkeitsstromdurchlass, der in Flüssigkeitsstromverbindung mit mehreren Flüssigkeitsstromdurchlasszweigen verbunden ist, umfasst.

6. Vorrichtung nach Anspruch 5, dadurch gekennzeichnet, dass die Verdampfungskammer und das poröse Wandelement in koaxialer Beziehung zueinander stehen und von länglicher Art mit einer gemeinsamen zentralen Längsachse sind, wobei sich der Mehrfach-Flüssigkeitsstromdurchlass linear und parallel zu der zentralen Längsachse erstreckt und wobei die mehreren Flüssigkeitsstromdurchlasszweige senkrecht zu der zentralen Längsachse liegen.

7. Vorrichtung nach einem der Ansprüche 1 bis 6, die zusätzlich Mittel umfasst zur Einspeisung von Trägergas in das innere Volumen der Verdampfungskammer, um während des Betriebes der Vorrichtung ein Gasgemisch zu bilden, das das Trägergas und den resultierenden Dampf umfasst.

8. Vorrichtung nach einem der Ansprüche 1 bis 7, dadurch gekennzeichnet, dass die Mittel zur Einspeisung von Trägergas in das innere Volumen der Verdampfungskammer ein längliches perforiertes Gaszuführungsrohr in dem inneren Volumen, das in Gasstromverbindung mit einer Quelle von Trägergas außerhalb der Verdampfungskammer steht, umfasst.

9. Vorrichtung nach einem der Ansprüche 1 bis 8, dadurch gekennzeichnet, dass die Mittel zur Zuführung des Ausgangsreagenzes in das innere Volumen des Gehäuses eine Pumpe umfassen, wobei diese Pumpe einschließt:
einen Pumpenblock mit einer inneren Pumpkammer;
einen in der Pumpkammer angeordneten Kolben zur Hin- und Herbewegung darin;
eine erste Flüssigkeitsdichtung, die in der Pumpkammer angebracht ist und um den Kolben herum angeordnet ist, um (i) die Dichtung zwischen dem Kolben und der Pumpkammer während der Hin- und Herbewegung des Kolbens in der Kammer zu bewirken und (ii) ein inneres Flüssigkeitspumpvolumen der Pumpkammer zu begrenzen;
eine zweite Fluiddichtung, die in der Pumpkammer angebracht und um den Kolben herum angeordnet ist, um die Dichtung zwischen dem Kolben und der Pumpkammer während der Hin- und Herbewegung des Kolbens in der Kammer zu bewirken, wobei sich die zweite Fluiddichtung in räumlich getrennter Beziehung zu der ersten Flüssigkeitsdichtung befindet, um dazwischen ein Zwischendichtungsvolumen der Pumpkammer zu definieren;
einen Einlassflüssigkeitsdurchlass, der mit dem inneren Pumpvolumen verbunden ist, zur Einführung der Zustromflüssigkeit;
einen Auslassflüssigkeitsdurchlass, der mit dem inneren Flüssigkeitspumpvolumen verbunden ist, um komprimierte Flüssigkeit daraus abzuleiten;
einen Fluideinlassdurchlass, der mit dem Zwischendichtungsvolumen der Pumpkammer verbunden ist, um ein Spülgas oder eine Spülflüssigkeit darin einzuführen; und
einen Fluidauslassdurchlass, der mit dem Zwischendichtungsvolumen der Pumpkammer verbunden ist, um Spülgas oder Spülflüssigkeit daraus abzuleiten,
wodurch ein Teil des Kolbens während der Hin- und Herbewegung desselben zwischen dem Flüssigkeitspumpvolumen der Pumpkammer und dem Zwischendichtungsvolumen der Pumpkammer verschoben wird.

10. Vorrichtung nach Anspruch 9, dadurch gekennzeichnet, dass das Flüssigkeitszuführungsmittel in Flüssigkeitszuführungsbeziehung mit dem Flüssigkeitseinlassdurchlass verbunden ist.

11. Vorrichtung nach Anspruch 9 oder 10, dadurch gekennzeichnet, dass das Spülfluidzuführungsmittel in Fluidzuführungsbeziehung mit dem Fluideinlassdurchlass verbunden ist.

12. Vorrichtung nach einem der Ansprüche 9 bis 11, dadurch gekennzeichnet, dass der Pumpenblock einen einheitlichen maschinell bearbeiteten Metallblock umfasst.

13. Verwendung einer Vorrichtung nach Anspruch 9 zum Durchführen eines Verfahrens zur Hemmung der Korrosion und/oder Teilchenbildung in der Pumpe, dadurch gekennzeichnet, dass die Pumpe angepasst ist zum Pumpen einer Flüssigkeit, die die Korrosion und/oder Teilchenbildung in Gegenwart von Sauerstoff und/oder anderen atmosphärischen Gasen bewirkt, wobei der sich hin- und herbewegende Kolben hin und her bewegbar ist zwischen einer ersten ausgestreckten Position in der Pumpkammer der Pumpe und einer zweiten zurückgezogenen Position außerhalb der Pumpkammer, so dass ein aktiv pumpender Teil des sich hin- und herbewegenden Kolbens nacheinander und wiederholt in Kontakt kommt mit Flüssigkeit in der Flüssigkeitspumpkammer und dann außerhalb der Flüssigkeitspumpkammer zurückgezogen wird, wobei der aktiv pumpende Teil des sich hin- und herbewegenden Kolbens außerhalb der Flüssigkeitspumpkammer mit einem inerten Fluid abgeschirmt wird, so dass der aktiv pumpende Teil des sich hin- und herbewegenden Kolbens daran gehindert wird, mit Sauerstoff oder anderen atmosphärischen Gasen in Kontakt zu kommen.

14. Verwendung nach Anspruch 13, wobei das inerte Fluid ausgewählt ist aus Argon, Stickstoff, Helium und Wasserstoff.

15. Verwendung nach Anspruch 13 oder 14, die des Weiteren umfasst: Hin- und Herbewegen des Kolbens in der Pumpkammer; Strömen der zugeführten Flüssigkeit durch den Einlassflüssigkeitsdurchlass in die Pumpkammer; Ableiten komprimierter Flüssigkeit aus der Pumpkammer durch den Auslassflüssigkeitsdurchlass; Strömen von Spülfluid durch den Fluideinlassdurchlass in das Zwischendichtungsvolumen der Pumpkammer; und Ableiten von Spülfluid aus dem Zwischendichtungsvolumen der Pumpkammer durch den Fluidauslassdurchlass.

16. Verwendung nach Anspruch 13 oder 14, wobei das Verfahren das Vermischen der Verfahrensflüssigkeit mit einer Flüssigkeitskomponente mit niedrigem Dampfdruck, die solvatisierend wirksam ist, zur Hemmung der Korrosion oder Teilchenbildung in einer für diese Inhibierung wirksamen Menge umfasst.

17. Verwendung nach Anspruch 16, wobei die Flüssigkeit mit niedrigem Dampfdruck ausgewählt ist aus Polyethern, Polyaminen und aromatischen Aminen.

18. Verwendung nach Anspruch 16, wobei die Flüssigkeit mit niedrigem Dampfdruck ausgewählt ist aus Tetraglyme, Triglyme, Diglyme, Tetraethylenpentamin und Triethylentetramin.

19. Verwendung nach einem der Ansprüche 16 bis 18, wobei die Verfahrensflüssigkeit eine Lösung eines Metallbetadiketonat-Komplexes in einem niedrigsiedenden Lösungsmittel ist und die Flüssigkeit mit niedrigem Dampfdruck ausgewählt ist aus Tetraglyme, Triglyme oder Diglyme.

20. Verwendung einer Vorrichtung nach Anspruch 9 zum Durchführen eines Verfahrens zur Hemmung der Korrosion und/oder Teilchenbildung in der Pumpe, gekennzeichnet durch mindestens eine der Stufen:
Vermischen der Verfahrensflüssigkeit mit einer Flüssigkeitskomponente mit niedrigem Dampfdruck, die solvatisierend wirksam ist zur Hemmung der Korrosion oder Teilchenbildung in einer für diese Hemmung wirksamen Menge; und
Abschirmen des Kolbens außerhalb der Pumpkammer mit einem inerten Fluid, so dass der aktiv pumpende Teil des sich hin- und herbewegenden Kolbens daran gehindert wird, mit Sauerstoff oder anderen atmosphärischen Gasen in Kontakt zu kommen.

21. Vorrichtung zum Verdampfen eines Ausgangsreagenzes nicht-dampfförmiger Art zur Erzeugung eines Dampfes zum Transport zu einem Verwendungsort, wobei diese Vorrichtung umfasst: eine Verdampfungskammer, umfassend ein Gehäuse, das darin ein abgeschlossenes inneres Verdampfungsvolumen definiert; Mittel zur Zuführung von Ausgangsreagenz in das innere Volumen des Gehäuses; Verdampfungsmittel, die innerhalb des inneren Volumens des Gehäuses angeordnet sind und in aufnehmender Beziehung zu dem Zuführungsmittel stehen, zum Aufnehmen des Ausgangsreagenzes und Bewirken von dessen Verdampfung; gekennzeichnet durch Mittel zum selektiven Zuführen in das innere Volumen zum In-Kontakt-Bringen mit den Verdampfungsmitteln und inneren Oberflächen des Gehäuses eines Reinigungsfluids, das reinigend wirksam ist, um mindestens teilweise Verdampfungsabscheidungen von den Verdampfungsmitteln und inneren Oberflächen des Gehäuses zu entfernen, welches in verdampftes-Reagenz-Strom-Beziehung verbunden ist mit einer in Strömungsrichtung nachfolgend angeordneten Abscheidungskammer und der Strom des Reinigungsfluids, Ausgangsreagenzes und des verdampften Reagenzes werden selektiv geregelt mit Strömungsregelungsmitteln von selektiv betätigbarer Art, wobei die Strömungsregelungsmittel untereinander verbunden sind mit einem Zyklenzeitmessmittel zum Erzeugen einer Abfolge von Verdampfung des Ausgangsreagenzes und dessen Zuführung zu der in Strömungsrichtung nachfolgend angeordneten Abscheidungskammer während eines vorbestimmten ersten Teils des Zyklus', gefolgt von der Beendigung des Stroms des Ausgangsreagenzes und des verdampften Reagenzes und dem Strömen des Reinigungsfluids in die Kammer zum Reinigen derselben, und wobei das Zyklenzeitmessmittel Mittel umfasst zum Messen einer Systemvariable, ausgewählt aus der Gruppe bestehend aus: einem Druckdifferential über den Verdampfer; der Flüssigkeitsleitfähigkeit durch den Verdampfer; Lichtreflektionsgrads von der Verdampferstruktur bei einer Wellenlänge, bei der dieser Reflektionsgrad durch die Ausbildung von Feststoffen verändert wird; die radiale thermische Leitfähigkeit des Verdampfers und Rückkopplungssignale von den Eigenschaften des wachsenden Films.

22. Verfahren zum Verdampfen eines nicht-dampfförmigen Ausgangsreagenzes und mindestens teilweisen Entfernen von Abscheidungsnebenprodukten einer solchen Verdampfung, wobei das Verfahren umfasst:
Bereitstellen einer Vorrichtung zum Verdampfen eines Ausgangsreagenzes von nicht-dampfförmiger Art zur Erzeugung eines Dampfes zum Transport zu einem Anwendungsort, wobei die Vorrichtung umfasst:
eine Verdampfungskammer, enthaltend ein Gehäuse, das darin ein eingeschlossenes inneres Verdampfungsvolumen definiert;
Mittel zum Zuführen von Ausgangsreagenz in das innere Volumen des Gehäuses;
Verdampfungsmittel, die im inneren Volumen des Gehäuses und in aufnehmender Beziehung zu den Zuführungsmitteln angeordnet sind, zum Aufnehmen von Ausgangsreagenz und Bewirken von dessen Verdampfung; und
Verdampfen des Ausgangsreagenzes in dem Gehäuse während einer vorbestimmten Zeitdauer und Strömen des resultierenden verdampften Reagenzes aus dem Gehäuse;
dadurch gekennzeichnet, dass:
die Vorrichtung Mittel umfasst zum selektiven Zuführen in das innere Volumen zum In-Kontakt-Bringen mit den Verdampfungsmitteln und inneren Oberflächen des Gehäuses eines Reinigungsfluids, welches reinigend wirksam ist, um mindestens teilweise Verdampfungsablagerungen von den Verdampfungsmitteln und inneren Oberflächen des Gehäuses zu entfernen; und
nach einer vorbestimmten Zeitdauer das Strömen des Ausgangsreagenzes und verdampften Reagenzes beendet wird und in das Gehäuse ein Reinigungsfluid strömt, welches reinigend wirksam ist, um mindestens teilweise Abscheidungen zu entfernen, die durch die Verdampfung erzeugt werden.

23. Verfahren nach Anspruch 22, das des Weiteren die Stufen umfasst des Leitens des verdampften Reagenzes, das aus dem Gehäuse strömt zu einer chemischen Dampfabscheidungszone und Bewirken der chemischen Dampfabscheidung aus dem verdampften Reagenz in der Zone.

24. Verfahren nach Anspruch 22 oder 23, wobei das Reinigungsfluid organisches Lösungsmittel umfasst.

25. Verfahren nach Anspruch 24, wobei das Reinigungsfluid ausgewählt ist aus mindestens einem der folgenden: Alkohole, Ether, Polyether, Polyamine oder Gemische davon.

26. Verfahren nach Anspruch 24, wobei das Reinigungsfluid ein Polyamin umfasst.

27. Verfahren nach Anspruch 22, wobei das Reinigungsfluid Fluorwasserstoff umfasst.

28. Verfahren nach Anspruch 22, wobei das Reinigungsfluid Tetrahydrofuran umfasst.

29. Verfahren nach Anspruch 22, wobei das Reinigungsfluid ein Lösungsmittel eines in dem Ausgangsreagenz vorhandenen Typs umfasst.

30. Verfahren nach Anspruch 22, wobei das Gehäuse in verdampftes-Reagenz-Strom-Beziehung verbunden ist mit einer in Strömungsrichtung nachfolgend angeordneten Ablagerungskammer und wobei das Strömen des Reinigungsfluidsausgangsreagenzes und des verdampften Reagenzes selektiv geregelt werden mit dem Strömungsregelungsmittel von selektiv betätigbarer Art.

31. Verfahren nach Anspruch 22, wobei die Strömungsregelungsmittel untereinander verbunden sind mit einem Zyklenzeitmessmittel zur Erzeugung einer Abfolge von Verdampfung des Ausgangsreagenzes und Zuführung desselben zu der in Strömungsrichtung nachfolgend angeordneten Abscheidungskammer während eines vorbestimmten ersten Teils des Zyklus', gefolgt von der Beendigung des Strömens des Ausgangsreagenzes und des verdampften Reagenzes und dem Strömen von Reinigungsfluid in die Kammer, um diese zu reinigen.

32. Chemisches Dampfabscheidungssystem, umfassend:
eine Vorrichtung zum Verdampfen einer verdampfbaren Flüssigkeit, umfassend:
eine Verdampfungskammer, die darin ein inneres Volumen enthält und mindestens teilweise durch eine einschließende innere Wandoberfläche begrenzt ist;
ein Verdampfungselement, das in der Verdampfungskammer angeordnet ist;
Mittel zum Erhitzen des Verdampfungselements auf eine Temperatur zur Verdampfung der verdampfbaren Flüssigkeit;
Mittel zum Zuführen verdampfbarer Flüssigkeit zu dem Verdampfungselement, umfassend ein Pumpenaggregat; und
Mittel zum Ableiten von Dampf aus dem inneren Volumen der Verdampfungskammer;
dadurch gekennzeichnet, dass:
(A) auf der einschließenden inneren Wandoberfläche ein Flüssigkeitsstromdurchlass gebildet ist;
(B) das Verdampfungselement mindestens ein poröses Wandelement mit inneren und äußeren Wandelementoberflächen umfasst, wobei das poröse Wandelement mit der äußeren Wandelementoberfläche davon in naher Beziehung zu der einschließenden inneren Wandoberfläche angeordnet ist, um zusammen damit den Flüssigkeitsstromdurchlass zu bilden, so dass die äußere Wandelementoberfläche des porösen Wandelements über dem Flüssigkeitsstromdurchlass liegt und so dass sich die innere Wandelementoberfläche des porösen Wandelements dem inneren Volumen der Verdampfungskammer darbietet;
(C) das Pumpenaggregat umfasst:
einen Pumpenblock mit einer inneren Pumpkammer;
einen in der Pumpkammer angeordneten Kolben zur Hin- und Herbewegung darin;
eine erste Flüssigkeitsdichtung, die in der Pumpkammer angebracht ist und um den Kolben herum angeordnet ist, um (i) die Dichtung zwischen dem Kolben und der Pumpkammer während der Hin- und Herbewegung des Kolbens in der Kammer zu bewirken und (ii) ein inneres Flüssigkeitspumpvolumen der Pumpkammer zu begrenzen;
eine zweite Fluiddichtung, die in der Pumpkammer angebracht und um den Kolben herum angeordnet ist, um die Dichtung zwischen dem Kolben und der Pumpkammer während der Hin- und Herbewegung des Kolbens in der Kammer zu bewirken, wobei sich die zweite Fluiddichtung in räumlich getrennter Beziehung zu der ersten Flüssigkeitsdichtung befindet, um dazwischen ein Zwischendichtungsvolumen der Pumpkammer zu definieren;
einen Einlassflüssigkeitsdurchlass, der mit dem inneren Pumpvolumen verbunden ist, zur Einführung der Zustromflüssigkeit;
einen Auslassflüssigkeitsdurchlass, der mit dem inneren Flüssigkeitspumpvolumen verbunden ist, um komprimierte Flüssigkeit daraus abzuleiten;
einen Fluideinlassdurchlass, der mit dem Zwischendichtungsvolumen der Pumpkammer verbunden ist, um ein Spülgas oder eine Spülflüssigkeit darin einzuführen; und
einen Fluidauslassdurchlass, der mit dem Zwischendichtungsvolumen der Pumpkammer verbunden ist, um Spülgas oder Spülflüssigkeit daraus abzuleiten,
wodurch ein Teil des Kolbens während der Hin- und Herbewegung desselben zwischen dem Flüssigkeitspumpvolumen der Pumpkammer und dem Zwischendichtungsvolumen der Pumpkammer verschoben wird; und
(D) Mittel zum selektiven Zuführen in das innere Volumen zum In-Kontakt-Bringen mit dem Verdampfungselement und den inneren Oberflächen des Gehäuses eines Reinigungsfluids, das reinigend wirksam ist, um mindestens teilweise Verdampfungsabscheidungen von dem Verdampfungselement und inneren Oberflächen des Gehäuses zu entfernen.

## Revendications

1. Appareil pour vaporiser un réactif source de type non vaporeux, pour produire une vapeur servant au transport jusqu'à un lieu d'utilisation, ledit appareil comprenant :
une chambre de vaporisation comprenant une enceinte définissant à l'intérieur de ses limites un volume intérieur fermé de vaporisation ;
des moyens pour fournir un réactif source au volume intérieur de l'enceinte ;
des moyens de vaporisation disposés dans le volume intérieur de ladite enceinte et en relation de réception avec les moyens d'alimentation, pour recevoir un réactif source et effectuer sa vaporisation ; et
des moyens pour fournir sélectivement au volume intérieur, afin d'établir le contact avec les moyens de vaporisation et les surfaces intérieures de l'enceinte, un fluide de nettoyage qui a une efficacité de nettoyage pour que les dépôts de vaporisation soient au moins partiellement éliminés desdits moyens de vaporisation et desdites surfaces intérieures de l'enceinte ;
caractérisé
en ce que la chambre de vaporisation comprend un passage d'écoulement du liquide formé sur une surface de paroi intérieure de fermeture de la chambre de vaporisation ;
en ce que les moyens de vaporisation comprennent au moins une paroi poreuse ayant des surfaces de paroi intérieure et extérieure où ladite paroi poreuse est positionnée en ayant sa surface extérieure à proximité de la surface de paroi intérieure de fermeture de la chambre de vaporisation, ledit passage d'écoulement du liquide étant formé sur cette surface de la paroi, de sorte que la surface extérieure de la paroi poreuse recouvre ledit passage d'écoulement du liquide et que la surface intérieure de la paroi poreuse est présentée au volume intérieur de la chambre de vaporisation ;
en ce que des moyens sont prévus pour chauffer la paroi poreuse à une température pour la vaporisation du liquide vaporisable ; et
en ce que les moyens pour fournir le réactif source au volume intérieur de l'enceinte fournissent le liquide vaporisable au passage d'écoulement du liquide, afin d'établir le contact avec la paroi poreuse chauffée à ladite température de vaporisation du liquide vaporisable, de sorte que la vapeur obtenue, formée par ledit contact, traverse ladite paroi poreuse jusqu'au volume intérieur de la chambre de vaporisation.

2. Appareil selon la revendication 1, caractérisé par une chambre de vaporisation de forme cylindrique.

3. Appareil selon la revendication 1 ou 2, caractérisé en ce que la chambre de vaporisation est de forme cylindrique, en ce que la paroi poreuse est de forme cylindrique et en ce que la surface extérieure de la paroi poreuse est contiguë à la surface de paroi intérieure de fermeture de la chambre de vaporisation, sur la totalité de la surface extérieure de la paroi poreuse.

4. Appareil selon l'une quelconque des revendications 1 à 3,
caractérisé en ce que la paroi poreuse est formée d'un matériau sélectionné à partir de matériaux métalliques frittés et à partir de matières céramiques poreuses.

5. Appareil selon l'une quelconque des revendications 1 à 4,
caractérisé en ce que le passage d'écoulement du liquide sur la surface de paroi intérieure de fermeture comprend au moins un passage d'écoulement du liquide formant collecteur relié, par communication d'écoulement du liquide, à plusieurs branches de passage d'écoulement du liquide.

6. Appareil selon la revendication 5, caractérisé en ce que la chambre de vaporisation et la paroi poreuse sont en relation coaxiale l'une par rapport à l'autre et en ce qu'elles sont de type allongé en ayant un axe central longitudinal commun, ledit passage d'écoulement du liquide formant collecteur s'étendant linéairement et parallèlement audit axe central longitudinal, ladite pluralité de branches du passage d'écoulement du fluide étant perpendiculaire audit axe central longitudinal.

7. Appareil selon l'une quelconque des revendications 1 à 6 qui comprend en outre des moyens pour introduire un gaz porteur dans ledit volume intérieur de ladite chambre de vaporisation, pour former un mélange de gaz comprenant ledit gaz porteur et ladite vapeur obtenue dans ce volume intérieur de la chambre de vaporisation au cours du fonctionnement dudit appareil.

8. Appareil selon l'une quelconque des revendications 1 à 7,
caractérisé en ce que lesdits moyens pour introduire un gaz porteur dans ledit volume intérieur de ladite chambre de vaporisation comprennent un tube perforé et allongé d'alimentation en gaz dans ledit volume intérieur, le tube étant relié, dans la communication de flux de gaz, à une source de gaz porteur, à l'extérieur de la chambre de vaporisation.

9. Appareil selon l'une quelconque des revendications 1 à 8,
caractérisé en ce que les moyens pour fournir un réactif source, au volume intérieur de l'enceinte, comprennent une pompe, où ladite pompe comprend :
un corps de pompe comprenant une cavité intérieure de pompage ;
un piston positionné dans la cavité de pompage pour un mouvement alternatif à l'intérieur de la cavité ;
un premier joint à liquide monté dans la cavité de pompage et disposé circonférentiellement autour du piston, (i) pour assurer l'étanchéité entre le piston et la cavité de pompage au cours du mouvement alternatif du piston dans la cavité, et (ii) pour limiter un volume intérieur de pompage du liquide de la cavité de pompage ;
un second joint à fluide monté dans la cavité de pompage et disposé circonférentiellement autour du piston, pour assurer l'étanchéité entre le piston et la cavité de pompage au cours du mouvement alternatif du piston dans la cavité, le second joint à fluide étant espacé par rapport au premier joint à liquide, pour définir un volume, entre joints, de la cavité de pompage;
un passage d'entrée du liquide relié au volume intérieur de pompage du liquide, pour l'introduction du liquide d'alimentation jusqu'à ce volume intérieur ;
un passage de sortie du liquide relié au volume intérieur de pompage du liquide, pour que le liquide pressurisé soit évacué de ce volume intérieur ;
un passage d'entrée du fluide relié au volume entre joints de la cavité de pompage, pour l'introduction d'un gaz ou d'un liquide de purge jusqu'à ce volume entre joints ; et
un passage de sortie du fluide relié au volume entre joints de la cavité de pompage pour qu'un gaz de purge ou un liquide soit évacué de ce volume entre joints,
où une partie du piston, au cours de son mouvement alternatif, suit un mouvement de translation entre le volume de pompage du liquide de la cavité de pompage et le volume entre joints de la cavité de pompage.

10. Appareil selon la revendication 9, caractérisé en ce que les moyens fournissant le liquide d'alimentation sont reliés, en fournissant le liquide, au passage d'entrée du liquide.

11. Appareil selon la revendication 9 ou 10, caractérisé en ce que les moyens d'alimentation en fluide de purge sont reliés, en fournissant le fluide, au passage d'entrée du fluide.

12. Appareil selon l'une quelconque des revendications 9 à 11, caractérisé en ce que le corps de pompe comprend un corps métallique unitaire usiné.

13. Utilisation d'un appareil selon la revendication 9, pour effectuer un processus afin d'empêcher la corrosion et/ou la formation de matières particulaires dans ladite pompe,
caractérisée en ce que ladite pompe est adaptée pour pomper un liquide empêchant ladite corrosion et/ou ladite formation de matières particulaires en présence d'oxygène et/ou d'autres gaz atmosphériques,
où le piston alternatif peut suivre un mouvement alternatif entre une première position sortie dans la cavité de pompage de la pompe, et une seconde position rentrée, à l'extérieur de la cavité de pompage, de sorte qu'une partie active du pompage du piston alternatif vient en contact séquentiellement et de façon répétée avec le liquide dans la chambre de pompage du liquide, puis est retirée à l'extérieur de la chambre de pompage du liquide, où la partie active de pompage du piston alternatif, à l'extérieur de la chambre de pompage du liquide, est recouverte d'un fluide inerte, de sorte que la partie active de pompage du piston alternatif est empêchée de venir en contact avec l'oxygène ou avec d'autres gaz atmosphériques.

14. Utilisation selon la revendication 13, dans laquelle le fluide inerte est sélectionné parmi l'argon, l'azote, l'hélium et l'hydrogène.

15. Utilisation selon la revendication 13 ou 14 qui comprend en outre le mouvement alternatif du piston dans la cavité de pompage ; l'écoulement du liquide d'alimentation à travers le passage du liquide d'entrée jusqu'à la cavité de pompage ; l'évacuation du liquide pressurisé sortant de la cavité de pompage, à travers le passage de sortie du liquide ; l'écoulement du fluide de purge à travers le passage d'entrée du fluide jusque dans le volume entre joints de la cavité de pompage et l'évacuation du fluide de purge sortant du volume entre joints de la cavité de pompage, à travers le passage de sortie du fluide.

16. Utilisation selon la revendication 13 ou 14, dans laquelle ledit processus comprend l'étape consistant à mélanger le liquide du processus avec un composant liquide à faible pression de vapeur qui est efficace, par solvatation, pour empêcher la corrosion ou la formation de matières particulaires, suivant une quantité efficace pour ladite action inhibitrice.

17. Utilisation selon la revendication 16, dans laquelle le liquide à faible pression de vapeur est sélectionné parmi des polyéthers, des polyamines et des amines aromatiques.

18. Utilisation selon la revendication 16, dans laquelle le liquide à faible pression de vapeur est sélectionné à partir du tétraglyme, du triglyme, du diglyme, de la tétraéthylènepentamine et de la triéthylènetétramine.

19. Utilisation selon l'une quelconque des revendications 16 à 18, dans laquelle le liquide du processus est une solution d'un complexe de bêta-dicétonate métallique dans un solvant à point d'ébullition bas, le liquide à faible pression de vapeur étant sélectionné parmi du tétraglyme, du triglyme ou du diglyme.

20. Utilisation d'un appareil selon la revendication 9, pour effectuer un processus afin d'empêcher la corrosion et/ou la formation de matières particulaires dans la pompe,
caractérisée par au moins une des étapes consistant :
à mélanger le liquide du processus avec un composant liquide à faible pression de vapeur qui est efficace, par solvatation, pour empêcher la corrosion ou la formation de matières particulaires suivant une quantité efficace pour ladite action inhibitrice ; et
à recouvrir l'extérieur du piston de la cavité de pompage avec un fluide inerte, de sorte que la partie active de pompage du piston alternatif est empêchée de venir en contact avec l'oxygène ou avec d'autres gaz atmosphériques.

21. Appareil pour vaporiser un réactif source de type non vaporeux, afin de produire une vapeur servant au transport jusqu'à un lieu d'utilisation, ledit appareil comprenant :
une chambre de vaporisation comprenant une enceinte définissant à l'intérieur de ses limites un volume intérieur fermé de vaporisation ;
des moyens pour fournir un réactif source au volume intérieur de l'enceinte ;
des moyens de vaporisation disposés dans le volume intérieur de ladite enceinte et en relation de réception avec les moyens d'alimentation, pour recevoir un réactif source et pour effectuer sa vaporisation ;
caractérisé par des moyens pour fournir sélectivement au volume intérieur, afin d'établir le contact avec les moyens de vaporisation et avec des surfaces intérieures de l'enceinte, un fluide de nettoyage qui a une efficacité de nettoyage pour que les dépôts de vaporisation soient au moins partiellement éliminés desdits moyens de vaporisation et desdites surfaces intérieures de l'enceinte reliée, dans la relation d'écoulement du réactif vaporisé, à une chambre de dépôt en aval, les flux du fluide de nettoyage, du réactif source et du réactif vaporisé étant sélectivement régulés avec des moyens de régulation de l'écoulement, ces moyens de régulation étant du type actionnable sélectivement et interconnectés avec des moyens de synchronisation du cycle, pour produire une séquence de vaporisation du réactif source et pour fournir ce même réactif source vaporisé à la chambre de dépôt en aval, pour une première partie prédéterminée du cycle, suivie de l'arrêt de l'écoulement du réactif source et du réactif vaporisé, et suivie de l'écoulement du fluide de nettoyage dans la chambre pour le nettoyage de celle-ci, les moyens de synchronisation du cycle comprenant des moyens pour détecter une variable du système sélectionnée parmi le groupe se composant : d'un différentiel de pression dans le vaporisateur ; de la conductance du fluide à travers le vaporisateur ; de la réflexion de la lumière hors de la structure du vaporisateur à une longueur d'onde où une telle réflexion est modifiée par la formation de solides ; de la conductance thermique radiale du vaporisateur et de la rétroaction des propriétés des films croissants.

22. Procédé de vaporisation d'un réactif source non vaporeux et d'élimination au moins partiellement de sous-produits de déposition d'une telle vaporisation, ledit procédé comprenant les étapes consistant :
à réaliser un appareil pour vaporiser un réactif source de type non vaporeux, afin de produire une vapeur servant au transport jusqu'à un lieu d'utilisation, ledit appareil comprenant :
- une chambre de vaporisation comprenant une enceinte définissant à l'intérieur de ses limites un volume intérieur fermé de vaporisation ;
- des moyens pour fournir un réactif source, au volume intérieur de l'enceinte ;
- des moyens de vaporisation disposés dans le volume intérieur de ladite enceinte et en relation de réception avec les moyens d'alimentation, pour recevoir un réactif source et pour effectuer sa vaporisation ; et
à vaporiser le réactif source dans l'enceinte pendant un laps de temps prédéterminé et à faire en sorte que le réactif vaporisé obtenu s'écoule hors de l'enceinte ;
caractérisé :
en ce que ledit appareil comprend des moyens pour fournir sélectivement au volume intérieur, afin d'établir le contact avec les moyens de vaporisation et les surfaces intérieures de l'enceinte, un fluide de nettoyage qui a une efficacité de nettoyage pour que les dépôts de vaporisation soient au moins partiellement éliminés desdits moyens de vaporisation et desdites surfaces intérieures de l'enceinte ; et
après un laps de temps prédéterminé, le procédé comprend l'étape consistant à achever l'écoulement du réactif source et du réactif vaporisé, et à faire en sorte qu'un fluide de nettoyage s'écoule dans ladite enceinte, le fluide de nettoyage ayant une efficacité de nettoyage pour que les produits de dépôts dus à ladite vaporisation soient au moins partiellement éliminés.

23. Procédé selon la revendication 22, comprenant en outre les étapes consistant à faire en sorte que le réactif vaporisé quitte l'enceinte pour s'acheminer jusqu'à une zone de dépôt chimique en phase vapeur et à effectuer le dépôt chimique en phase vapeur à partir du réactif vaporisé dans ladite zone.

24. Procédé selon la revendication 22 ou 23, dans lequel le fluide de nettoyage comprend un solvant organique.

25. Procédé selon la revendication 24, dans lequel le fluide de nettoyage est sélectionné parmi au moins un des éléments suivants tels que des alcools, des éthers, des polyéthers, des polyamines ou des mélanges de ces éléments.

26. Procédé selon la revendication 24, dans lequel le fluide de nettoyage comprend une polyamine.

27. Procédé selon la revendication 22, dans lequel le fluide de nettoyage comprend du fluorure d'hydrogène.

28. Procédé selon la revendication 22, dans lequel le fluide de nettoyage comprend du tétrahydrofurane.

29. Procédé selon la revendication 22, dans lequel le fluide de nettoyage comprend un solvant d'un type présent dans le réactif source.

30. Procédé selon la revendication 22, dans lequel l'enceinte est reliée, dans la relation d'écoulement du réactif vaporisé, à une chambre de dépôt en aval, et où les flux du fluide de nettoyage, du réactif source et du réactif vaporisé sont régulés sélectivement avec les moyens de régulation d'écoulement, ces moyens de régulation étant du type actionnable sélectivement.

31. Procédé selon la revendication 22, dans lequel les moyens de régulation d'écoulement sont interconnectés avec des moyens de synchronisation du cycle, pour produire une séquence de vaporisation du réactif source et pour fournir ce même réactif source vaporisé à la chambre de dépôt en aval, pendant une première partie prédéterminée du cycle, suivie de l'arrêt de l'écoulement du réactif source et du réactif vaporisé, et suivie de l'écoulement du fluide de nettoyage dans la chambre de dépôt pour le nettoyage de celle-ci.

32. Système de dépôt chimique en phase vapeur, comprenant :
un appareil pour vaporiser un liquide vaporisable, comprenant :
une chambre de vaporisation renfermant un volume intérieur et limité au moins partiellement par une surface de paroi intérieure de fermeture ;
un élément de vaporisation disposé dans ladite chambre de vaporisation ;
des moyens pour chauffer l'élément de vaporisation à une température de vaporisation du liquide vaporisable ;
des moyens pour fournir un liquide vaporisable, à l'élément de vaporisation comprenant une pompe ; et
des moyens pour évacuer la vapeur sortant du volume intérieur de la chambre de vaporisation ;
caractérisé :
(A) par un passage d'écoulement du liquide formé sur ladite surface de paroi intérieure de fermeture ;
(B) par des moyens de vaporisation comprenant au moins une paroi poreuse ayant des surfaces de paroi intérieure et extérieure où ladite paroi poreuse est positionnée en ayant sa surface extérieure à proximité de la surface de paroi intérieure de fermeture, pour former, en coopération avec cette surface de paroi intérieure de fermeture, ledit passage d'écoulement du liquide, de sorte que la surface extérieure de la paroi poreuse recouvre ledit passage d'écoulement du liquide et que la surface intérieure de la paroi poreuse est présentée au volume intérieur de la chambre de vaporisation ;
(C) par ledit ensemble de pompage comprenant :
un corps de pompe comprenant une cavité intérieure de pompage ;
un piston positionné dans la cavité de pompage pour un mouvement alternatif à l'intérieur de la cavité ;
un premier joint à liquide monté dans la cavité de pompage et disposé circonférentiellement autour du piston, (i) pour assurer l'étanchéité entre le piston et la cavité de pompage au cours du mouvement alternatif du piston dans la cavité, et (ii) pour limiter un volume intérieur de pompage du liquide de la cavité de pompage ;
un second joint à fluide monté dans la cavité de pompage et disposé circonférentiellement autour du piston, pour assurer l'étanchéité entre le piston et la cavité de pompage au cours du mouvement alternatif du piston dans la cavité, le second joint à fluide étant espacé par rapport au premier joint à liquide, pour définir un volume, entre joints, de la cavité de pompage;
un passage d'entrée du liquide relié au volume intérieur de pompage du liquide, pour l'introduction du liquide d'alimentation jusqu'à ce volume intérieur ;
un passage de sortie du liquide relié au volume intérieur de pompage du liquide, pour que le liquide pressurisé soit évacué de ce volume intérieur ;
un passage d'entrée du fluide relié au volume entre joints de la cavité de pompage, pour l'introduction d'un gaz ou d'un liquide de purge jusqu'à ce volume entre joints ; et
un passage de sortie du fluide relié au volume entre joints de la cavité de pompage pour qu'un gaz de purge ou un liquide soit évacué de ce volume entre joints,
où une partie du piston, au cours de son mouvement alternatif, suit un mouvement de translation entre le volume de pompage du liquide de la cavité de pompage et le volume entre joints de la cavité de pompage ; et
(D) par des moyens pour fournir sélectivement au volume intérieur, afin d'établir le contact avec l'élément de vaporisation et avec les surfaces intérieures de l'enceinte, un fluide de nettoyage qui a une efficacité de nettoyage pour que les dépôts de vaporisation soient au moins partiellement éliminés dudit élément de vaporisation et desdites surfaces intérieures de l'enceinte.
